(19) Europäisches Patentamt
European Patent Office
Office européen des brevets

(11) EP 3 077 130 B1

(12) **EUROPEAN PATENT SPECIFICATION**

(45) Date of publication and mention of the grant of the patent:
**27.01.2021 Bulletin 2021/04**

(21) Application number: **13838047.2**

(22) Date of filing: **06.12.2013**

(51) Int Cl.:
***B08B 17/06*** *(2006.01)* ***G02B 1/11*** *(2015.01)*
***G02B 27/00*** *(2006.01)*

(86) International application number:
**PCT/IB2013/002938**

(87) International publication number:
**WO 2015/082948 (11.06.2015 Gazette 2015/23)**

(54) **MANUFACTURED ARTICLE WITH A NANOSTRUCTURED SURFACE**

HERGESTELLTER ARTIKEL MIT EINER NANOSTRUKTURIERTEN OBERFLÄCHE

ARTICLE MANUFACTURÉ DOTÉ D'UNE SURFACE NANOSTRUCTURÉE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**12.10.2016 Bulletin 2016/41**

(73) Proprietors:
- **Essilor International**
**94220 Charenton-le-Pont (FR)**
- **Nikon Corporation**
**Minato-ku**
**Tokyo 108-6290 (JP)**

(72) Inventors:
- **COUDERC, Sandrine**
**Tokyo 154-0004 (JP)**
- **DELYON, Romain**
**F-91800 Brunoy (FR)**
- **TORTISSIER, Grégory**
**Kawasaki-shi**
**Kanagawa 213-0013 (JP)**

(74) Representative: **Jacobacci Coralis Harle**
**32, rue de l'Arcade**
**75008 Paris (FR)**

(56) References cited:
**WO-A1-2011/094344** **WO-A1-2011/106196**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 077 130 B1

## Description

The present invention concerns a manufactured article with a nanostructured surface (also designated as a nanotextured surface) exhibiting omniphobicity, droplet fractioning and confinement, stability of wetting properties under pressure and potential for achieving mechanical robustness. Omniphobicity means that the structured surface can repel both water and oil (and more generally any kind of solvent). These kinds of surfaces are able to repel various liquids but also to fractionate a film of oily and viscous liquid (like sebum) into small droplets.

In the field of structured surfaces, two main types of structured surfaces are to be considered.

The first type of structured surface is a so-called open structure which consists in an array of separated pillars distributed regularly or not on the surface, the space between the pillars being interconnected with each other, thus forming a continuous interspace between the pillars. The pillars can be of different shapes typically of a straight shape (i.e. the pillars have an almost constant cross-section from base to top), an overhanging shape (i.e. the top of the pillar comprises a cap of larger size than the cross-section of the body of the pillar), or a re-entrant shape (i.e. the cross-section of the pillar diminishes from the top to the base).

The main shortcoming of these open structures such as an overhang structure for achieving omniphobicity is the difficulty for the structure to maintain the liquid repellency property when the liquid is subjected to a pressure. It means that the surface is not able to maintain the liquid above the structure with air beneath it (Cassie-Baxter or "fakir" state) when a pressure is applied on the liquid and as a consequence, the liquid propagates inside the structure leading to a fully wetted state (Wenzel state). This situation can occur, for example, when a droplet of sebum is fingerprinted on the surface (pressure applied $\approx 2.5\ 10^4$ Pa) or when a water drop coming from rain or wash impacts the surface (pressure varying from $\approx 20$ Pa to $4.5\ 10^4$ Pa depending on rain conditions).

Such open structured surfaces are disclosed, in particular in the following publications:

- A. Tuteja, W. Choi, M.L. Ma, J.M. Mabry, S.A. Mazzella, G.C. Rutledge, G.H. McKinley and R.E. Cohen, Designing Superoleophobic Surfaces, Science, 2007, 318, 1618-1622, Massachusetts Institute of Technology, Cambridge, Massasuchetts / Air Force Research Laboratory, California, USA
- A. Ahuja, J.A. Taylor, V. Lifton, A.A. Sidorenko, T.R. Salamon, E.J. Lobaton, P. Kolodner and T.N. Krupenkin, Nanonails: A Simple Geometrical Approach to Electrically Tunable Superlyophobic Surfaces, Langmuir 2008, 24, 9-14, Bell Laboratories, Lucent Technologies, New Jersey, USA
- A. Tuteja, W. Choi, G.H. McKinley, R.E. Cohen and M.F. Rubner, Design Parameters for Superhydrophobicity and Superoleophobicity, MRS Bull., 2008, 33, 752-758, Massachusetts Institute of Technology, Cambridge, Massasuchetts / Air Force Research Laboratory, California, USA

It has been reported that best results for wetting robustness were obtained for micro-hoodoos surfaces which are capable to support a pressure $\approx 1.5\ 10^4$ Pa for octane. These results are not high enough regarding the anti-rain and anti-fingerprint functions. Furthermore, these open structured surfaces suffer from a lack of mechanical robustness caused by the fact that each structured element is a stand-alone element not bound with surrounding elements.

The second type of structure is the structure which consists in an array of contiguous cells defining cavities separated by solid material walls and opened to the environment.

Different kinds of structures of second type have been proposed, such as honeycomb, pin cushion and box or brick structures.

M.C. Salvadori, M. Cattani, M.R.S. Oliveira, F.S. Teixeira and I.G. Brown, "Design and fabrication of microcavity-array superhydrophobic surfaces", J. Appl. Phys., 2010, 108, 024908, University of Sao Paulo, Sao Paulo, Brazil, disclose the formation of periodic microstructures which are microcavities. They developed a theoretical model that allows calculation of the microcavity dimensions needed to obtain superhydrophobic surfaces composed of patterns of such microcavities, and that provides estimation of the advancing and receding contact angles as a function of microcavity parameters. The model predicts that the cavity aspect ratio (depth to diameter ratio) can be much less than unity, indicating that the microcavities do not need to be deep in order to obtain a surface with enhanced superhydrophobic character. The cavities of the article are of a micrometric size.

United States Patent Application US-2010/0112286 (Bahadur et al.) discloses structured surfaces of the second type (i.e. non communicating cells) that offer a higher resistance to water droplet transition from the Cassie-Baxter state to the Wenzel state than equivalent pillar surfaces (open structure).

The resistance to the Cassie-Baxter/Wenzel transition is measured in terms of the electrowetting (EW)/voltage used to trigger the transition.

The cells are of a micrometer size and there is no indication of the sinking value of a droplet under pressure as well as of the cell cavities depth and radius.

International Patent Application (PCT) WO-2011/106196 (Mazumder et al.) discloses oleophobic glass substrates having a structured surface with cavities having different sizes (depth, radius, edge).

When a liquid droplet penetrates the cavity with a penetration depth h*, the situation corresponds to a partially wetted state. This document proposes a theoretical model for calculating the equilibrium penetration depth h* as a function of the radius (R) and height (H) of the cavity. However, this model does not include the effect of pressure applied on the liquid and does not consider the presence of an intervening air layer for the calculation.

International Patent Applications (PCT) WO-2011/094508 (Hatton et al.) and WO-2011/094344 (Hatton et al.) disclose hydrophobic structured surfaces of the second type having cell sizes ranging from a few nanometers to a thousand of micrometers.

Article "Transparency and damage tolerance of patternable omniphobic lubricated surfaces based on inverse colloidal monolayers". Nature Communications, 4:2167, DOI:10.1038/ncomms3176, published on 31 July 2013 discloses transparent nanoporous surface structures having a lubricant firmly locked into the structures. Inverse monolayers structures are created having a size ranging from 140 nm to 1060 nm. Once the lubricant has been infused, this structure is described as repelling aqueous and organic liquids due to a liquid/liquid interface.

It is to be noted that none of the above cited documents addresses the problem of resistance to smudging due to fingerprints. In other words, there is no teaching in the above-cited prior art regarding the choice of the ranges of the cavity size parameters, specifically in the nanometer scale, in order to provide a structure surface which exhibits omniphobicity, droplet fractioning and confinement, stability of wetting properties under pressure and potential for achieving mechanical robustness. In particular, there is no teachings in the above-cited prior art regarding cavity size parameters for limiting the sinking ($\alpha$) of an oil drop (typically a linoleic acid drop) under application of a pressure (typically a pressure corresponding to a fingerprint).

Thus, one aim of the present invention is to provide a manufactured article, in particular a transparent article, comprising at least one nanostructured surface of the second type whose cavity size parameters are selected to achieve the above goals and in particular a low sinking value with regard to an oily drop applied under pressure on the structured surface of the article.

Furthermore, when increasing the pressure applied on a liquid drop on the nanostructured surface, the penetration of the liquid within the structure increases. Depending upon the height and the radius of the structure, the surface energy of the material of the nanostructure, the nature of the liquid drop and the value of the applied pressure, the drop meniscus can come into contact with the bottom of the structure, resulting in a total invasion of the structure by the liquid. The pressure at which total invasion of the structure arises is called the "breakthrough pressure".

Thus, an additional aim of the present invention is to provide a manufactured article as above which exhibits high breakthrough pressure both for aqueous or oily liquids.

Another aim is to provide a manufactured article solving one or both aim above wherein the nanostructured surface provides a solid/air interface with the liquid drops in contact with the nanostructured surface instead of a liquid/liquid interface.

One or more of the preceding goals are obtained by providing a manufactured article comprising at least one nanostructured surface, wherein:

- said nanostructured surface is made of a material having a surface energy of less than 25 $mJ/m^2$, preferably less than 20 $mJ/m^2$, and comprises an array of contiguous cells defining cavities,
  the cavities of the cells being separated from each other by intermediate solid material walls, and opened to the environment
  and
- the cavities have an average height (H) and an average radius (R) which meet the conditions:

  $R \geq 5$ nm, preferably $R \geq 10$ nm;
  $R \leq 250$ nm, preferably $R \leq 200$ nm, better $R \leq 150$ nm and more preferably $R \leq 100$ nm; and
  $H \leq 3R$, better $H < 3R$, preferably $H \leq 1.5R$, preferably $H < 1.5R$ and more preferably $H \leq 0.5R$.

DESCRIPTION OF CAVITY

The nanostructured surface comprises an array of juxtaposed cells defining cavities, the cavities of the cells being separated from each other by intermediate solid walls and opened to the environment.

The top-view geometry of the cavity, the sidewall shape between two consecutive cavity structures, the top wall profile, and the spatial arrangement of the structures on the substrate can vary. Different structured surfaces can be formed based on the combination of all these features.

Some examples of cavity geometry and spatial arrangement are given in Fig. 1.

The topside geometry of the cavity structure can be regularly, irregularly or randomly shaped. Examples of such shape include but are not limited to, square (delimited by four identical walls), rectangular (delimited by four walls and each two opposite walls are identical), triangular (i.e., delimited by three walls), hexagonal (i.e., delimited by six

walls), circular or elliptical (i.e., delimited by one wall), randomly-shaped cavity, and a combination thereof.

The arrangement of the pattern can be a combination of various random or periodical cavity shapes having same or different size, symmetrically, asymmetrically arranged or randomly positioned. It can also be an alternation of random and periodical-shaped cavity structures having symmetrical or random spatial organization or arranged with a combination thereof. Examples of symmetrical spatial arrangement include, but are not limited to, square, hexagonal, octagonal, and staggered.

The width of the wall between two adjacent cavities can be constant along its height or it can vary. Thus, the profile of the wall can be straight (perpendicularly oriented to the substrate), oblique, curvy, re-entrant or overhang. For example the shape can be columnar, conical, pyramidal, prismatic, curved, inverse trapezoidal, or a combination between columnar and rounded. The angle formed between the horizontal plane and the wall side is defined by $\beta$ and is named the entrance angle. $\beta$ can vary from 0° up to 110°. The top wall of the cavity can be flat, rounded or sharp.

The bottom of cavity can be flat-bottomed or have a surface free of angles such as round-bottomed or cut out in several angles that are less than or equal to 90°.

DEFINITION OF AVERAGE WIDTH, HEIGHT AND RADIUS OF THE CAVITY

The wall width of the cavity corresponds to the distance between two adjacent cavities at the highest position on the wall of the cross-section plane defining the cavity entrance opening (see Fig. 1 for more details).

The average width (d) is the average value of the wall width (as defined above) for a set of cavity patterns arranged in an area of 10$\mu$mx10$\mu$m of the structure surface.

The height of the cavity refers to the highest distance between a point in the cross-section plane defining the entrance opening of the cavity and its normal projection on the base plane of the cavity structure.

The average height (H) is the average value of the height of the cavity (as defined above) for a set of cavity patterns arranged in an area of 10$\mu$mx10$\mu$m of the structure surface.

The radius of the cavity refers to the maximum half-distance in the cavity between two diametrically opposed points of the orthogonal projection of the cavity "entrance" opening on the base plane.

The average radius (R) is the average value of the radius of the cavity (as defined above) for a set of cavity patterns arranged in an area of 10$\mu$mx10$\mu$m of the structure surface.

The base plane is defined as a plane orthogonal to the main axis of the cavity and including the lowest point of the cavity.

The present invention is also directed to a theoretical model for calculating the sinking ($\alpha$) of an oily liquid applied under pressure on the nanostructured surface as a function of the average radius (R) and average height (H) of the cavity. The above goals are achieved, according to the invention, by providing a manufactured article comprising at least one nanostructured surface, wherein:

- said nanostructured surface is made of a material having a surface energy of less than 25 mJ/m$^2$, preferably less than 20 mJ/m$^2$ and comprises an array of juxtaposed cells defining cavities, the cavities of the cells being separated from each other by intermediate solid walls, and

the cavities have an average height (H) and an average radius (R) which meet the following conditions : R $\geq$ 5 nm, preferably R $\geq$ 10 nm;
R $\leq$ 250 nm, preferably R $\leq$ 200 nm, better R $\leq$ 150 nm and more preferably R $\leq$ 100 nm; and
H $\leq$ 3R, better H < 3R, preferably H $\leq$ 1.5R, preferably H < 1.5R and more preferably H $\leq$ 0.5R.

In another embodiment 2R<H<3R

In a preferred embodiment of the invention, the sinking ($\alpha$) is equal to or lower than 50%, wherein

$$\alpha(\%) = \frac{h}{H}100$$

where h is the wetting height by a liquid of the cavity intermediate wall and H is the average height of the cavity (as defined in Fig. 4).

In another embodiment, the sinking ($\alpha$) is lower than or equal to 30%.

More preferably, sinking ($\alpha$) ranges from 10% to less than 30% and average height H of the cavity meets the condition H $\leq$ 1.5 R.

In a still preferred embodiment, cavity average height H meets the condition H $\leq$ 0.5R and sinking ($\alpha$) is less than 10%.

Sinking ($\alpha$) may either be actually measured or determined using a theoretical model as disclosed below.

Depending upon the relative values of the entrance angle (β) and the static contact angle ($\theta_{stat}$) of the liquid onto a flat surface (made of the same material as the nanostructured surface), the shape of the liquid meniscus over the cavity is different (the meaning of static contact angle $\theta_{stat}$ is explained in Figure 2).

When $\beta \leq \theta_{stat}$ (see figures 5A and 6A), the liquid meniscus is convex and there is few sinking and in that case, the major risk is a breakthrough of the liquid drop under application of pressure on the liquid drop if the meniscus touches the bottom of the cavity structure.

When $\beta > \theta_{stat}$ (see figures 5B and 6B), the liquid meniscus is concave, sinking is generally important and increases with the pressure applied on the liquid drop.

Nevertheless, it is worth to say that breakthrough is also to be avoided.

The inventors have determined that, generally, the total invasion of the liquid inside the cavity can be avoided if the average height H of the cavity meets the requirement:

$$H > R\frac{1-\sin\theta_{adv}}{\left|\cos\theta_{adv}\right|}$$

where $\theta_{adv}$ is the advancing angle of the liquid onto a flat surface made of the same surface material than the nanostructured surface.

By made of the same material it is meant that the material of the flat surface is constituted of the same material as the nanostructured surface and has, if necessary, been subjected to the same treatments or coated with the same materials as the nanostructured surface.

Typically, the minimum average height of the cell cavity is $H > 0.20\,R$, preferably $H \geq 0.25\,R$ and even better $H \geq 0.3R$.

Preferably, the geometrical solid fraction (φ) of a cell array according to the invention will be equal to or lower than 0.7, preferably equal to or lower than 0.5 and even better equal to or lower than 0.3.

The geometrical solid fraction (φ) is defined from structure top view perspective as the ratio of solid surface area of the nanostructured surface to the total surface area of the nanostructured surface (solid and air areas).

The cell array is preferably a periodical array.

The cell cavities may have a circular, oval or polygonal shape such as square, rectangular and hexagonal shapes. Preferably, the cavities are of cylindrical shape in a hexagonal arrangement (Fig. 3 and Fig. 5).

The surface material of the nanostructured surface of the article exhibits a surface free energy lower than $25mJ/m^2$ and preferably lower than $20mJ/m^2$.and better lower than 14 $mJ/m^2$ and even lower than 12 $mJ/m^2$ The nanostructure surface can be made of low surface energy material such as fluorinated resins or fluorinated polymers or it can be coated with a low surface energy coating. In general, such a low surface energy coating comprises at least one of a fluoropolymer or a fluorosilane. Such fluoropolymers or fluorosilanes include, but are not limited to, Teflon® and commercially available fluorosilanes such as Dow Corning 2604, 2624 and 2634; Daikin Optool DSX®, Shinetsu OPTRON®, heptadecafluorosilane (manufactured, for example, by GELEST), FLUOROSYL® (manufactured, for example, by CYTONIX); etc. Such coatings can be applied to the nanostructured surface of the article by dipping, vapor coating, spraying, application with a roller, and other suitable method known in the art.

Compositions containing fluorosilanes recommended for the preparation of hydrophobic and/or oleophobic topcoats are described in U.S. Pat. No. 6,183,872. They contain fluoropolymers with organic groups carrying silicon-based groups represented by the following general formula and with a molecular weight of $5.10^2$ to $1.10^5$:

(1)

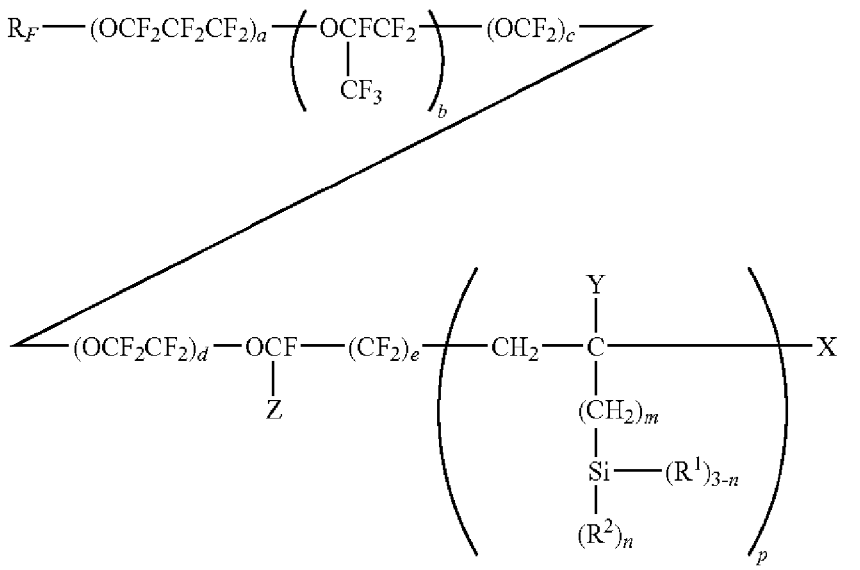

in which $R_F$ represents a perfluoroalkyl group; Z represents a fluoro or trifluoromethyl group; a, b, c, d and e each representing, independently from each other, 0 or an integer greater than or equal to 1, provided that the sum a+b+c+d+e is not less than 1 and that the order of the repeated units between the brackets indexed under a, b, c, d and e are not limited to the one given; Y represents H or an alkyl group comprising from 1 to 4 carbon atoms; X represents an atom of hydrogen, bromine or iodine;

$R^1$ represents an hydroxyl group or a hydrolysable group; $R^2$ represents an atom of hydrogen or a monovalent hydrocarbon group; m represents 0, 1 or 2; n represents 1, 2 or 3; and p represents an integer equal to at least 1, preferably equal to at least 2.

Particularly preferred are perfluoropolyethers of formula:

(1′)

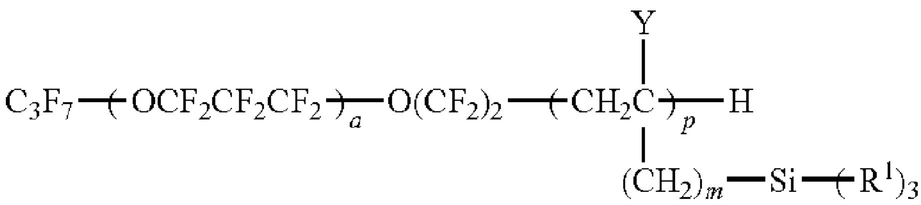

wherein Y, $R^1$, m and p are as defined above and a is an integer from 1 to 50.

A formulation containing a fluorosilane given by the previous formula (1) is marketed by DAIKIN INDUSTRIES with the name OPTOOL DSX®.

The document JP 2005 187936 describes fluorinated compounds of silane suitable for forming anti-smudge coatings and particularly compounds given by the formula:

(2)

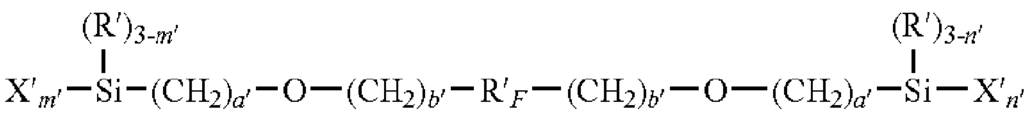

wherein

- $R'_F$ is a linear chain divalent perfluoropolyether radical,
- R' is an alkyl radical in $C_1$-$C_4$ or a phenyl radical,

X' is a hydrolysable group,
a' is an integer from 0 to 2,
b' is an integer from 1 to 5, and
m' and n' are integers equal to 2 or 3.

A fluorosilane compound given by the formula (2) above is marketed by SHIN-ETSU CHEMICAL CO, Ltd with the name KY-130®.

Fluorosilane compounds given by the formula (2) and methods for preparing them are also described in the patent application EP 1 300 433.

Preferably, the article of the invention has a curved surface.

More preferably, the article of the invention is a transparent article such as an optical article, and in particular an ophthalmic lens.

For such a transparent article, the radius and height of the cavities shall be such that R ≤ 100 nm and H ≤ 200 nm and the geometrical solid fraction shall be φ ≤ 0.5, preferably φ ≤ 0.3.

According to an embodiment of the invention, the nanostructured surface of the article according to the invention has an apparent static contact angle with water equal or higher than 130° and an apparent static contact angle with linoleic acid equal to or higher than 110°.

According to another embodiment of the invention, the article according to the invention has an apparent static contact angle with water equal or higher than 135° and an apparent static contact angle with linoleic acid equal to or higher than 115°.

The nanostructured surfaces of the article of the invention can be made by known conventional processes, such as nano imprinting lithography or e-beam lithography technique.

Sinking (α) can be determined using a measurement method or calculated using a theoretical model.

As measurement methods, it can be cited freezing the liquid or hardening a fluid having the same surface tension as the liquid to probe (using for example UV photoinitiator or UV curable resin) and measure the sinking by checking the shape of the solidified liquid by SEM (scanning electron microscopy).

The theoretical model for calculation of sinking (α) is:

$$\alpha = \frac{\left(1 + \frac{R}{H} f(\theta_{adv})\right)\left(P_a + \frac{2\gamma \cos\theta_{adv}}{R}\right) - \frac{V_i}{V_0} P_0}{P_a + \frac{2\gamma \cos\theta_{adv}}{R}}$$

with

Pa: hydrostatic pressure → $Pa = P_0 + \rho gz + \Delta P$
$P_0$: atmospheric pressure
ρgz: pressure caused by gravity of the liquid drop
ΔP: external pressure applied onto the drop
γ : liquid surface tension
R: average radius of the cavity
H: average height of the cavity
d: average distance between two cavities (wall width)
$\theta_{adv}$: advancing angle of the liquid onto a flat surface (same material and coating but without any structure)
$V_0$: geometrical volume of one cavity → $V_0 = \pi R^2 H$
Vi: total volume of the cavity including the volume of air trapped by the liquid when this one contacts the surface

$$V_i = \pi R^2 H + e\frac{\sqrt{3}}{2}(2R + d)^2$$

e : thickness of the air layer trapped by the liquid (schematic on Fig. 7 explained the phenomena)

f(θ): coefficient → for cylindrical cavity: $f(\theta) = \frac{1 - \sin\theta}{6\cos\theta}\left[3 + \frac{(1 - \sin\theta)^2}{\cos\theta^2}\right]$

The parameters R, H and d of the cavities are obtained as described before.

In the case the cavities have wall side profile forming an angle $\beta$ (different than 90°) with an horizontal plane of the nanostructured surface $\theta_{adv}$ is replaced by ($\theta_{adv} + \pi/2-\beta$).

The present invention also concerns a method for designing a nanostructured surface comprising an array of juxtaposed cells defining cavities separated from each other by solid intermediate walls, said method comprising:

- obtaining a map of areas of different values of the sinking ($\alpha$) in function of the radius (R) and the height (H) of the cavities, said values of the sinking ($\alpha$) being calculated using the theoretical model:

$$\alpha = \frac{\left(1 + \frac{R}{H} f(\theta_{adv})\right)\left(P_a + \frac{2\gamma\cos\theta_{adv}}{R}\right) - \frac{V_i}{V_0} P_0}{P_a + \frac{2\gamma\cos\theta_{adv}}{R}}$$

with

Pa: hydrostatic pressure → Pa= $P_0+\rho gz + \Delta P$
$P_0$: atmospheric pressure
$\rho gz$: pressure caused by gravity of the liquid drop
$\Delta P$: external pressure applied onto the drop
$\gamma$ : liquid surface tension
R: radius of the cavity
H: height of the cavity
d: distance between two cavities (wall width)

$\theta_{adv}$: advancing angle of the liquid onto a flat surface (same material and coating but without any structure)
$V_0$: geometrical volume of one cavity → $V_0 = \pi R^2 H$
Vi: total volume of the cavity including the volume of air trapped by the liquid when this one contacts the surface

$$V_i = \pi R^2 H + e \times \frac{\sqrt{3}}{2}(2R + d)^2$$

e : thickness of the air layer trapped by the liquid (schematic on Fig. 7 explained the phenomena)

f($\theta$): coefficient → for cylindrical cavity: $f(\theta) = \frac{1-\sin\theta}{6\cos\theta}\left[3 + \frac{(1-\sin\theta)^2}{\cos\theta^2}\right]$

- selecting values of radius (R) and height (H) for the cavities according to a desired sinking value; and
- forming the cell array with the selected values for the radius (R) and height (H) of the cavities.

BRIEF DESCRIPTION OF THE FIGURES

Figure 1 represents some examples of nanostructured surface having different cavity geometries, pattern spatial arrangement, wall side shape and bottom shape.

Figure 2 explained the behavior of a liquid drop deposited onto a flat surface with notations of the different contact angles formed by the liquid with the surface whether the surface is tilted or not. The advancing contact angle $\theta_{adv}$ and the receding contact angle $\theta_{rec}$ are the contact angles in the front and rear positions of the drop respectively and defined for a tilted surface at the angle (called sliding angle) where both front and rear contact points start to move.

Figure 3 represents schematic cross section and top views of nanocavities and notations;

Figure 4 is a cross-section schematic view of a linoleic acid drop onto a nanocavity with a pressure $\Delta P$ applied on it and wherein Pc and Vc are respectively the pressure and the air volume inside the cavity at the equilibrium ;

Figures 5A and 5B are cross-section schematic views of a water drop (5A) and an oil drop (5B) onto a nanocavity with the contribution of each pressure;

Figures 6A and 6B are cross-section schematic views of a liquid drop on the cavity surface having different wall shapes : re-entrant wall shape (6A) and curved wall shape (6B)

Figure 7 represents cross-section schematic views explaining the phenomena of air trapped when a liquid contacts the surface of the array of nanometric cells;

Figures 8A and 8B are AFM images of nanocavity structures being made of CycloOlefin Polymer (COP) for two designs : design 1 with a solid fraction (φ) of 0.47 and design 2 with a solid fraction (φ) of 0.3 respectively;

Figures 9A and 9B are AFM images of nanocavity structures being made of OrmoStamp ® (UV curable resin from Micro Resist Technology GmbH) for two designs : design 1 with a solid fraction (φ) of 0.47 and design 2 with a solid fraction (φ) of 0.3 respectively;

Figure 10 represents a graph of the transmittance in the visible range (400 nm-800 nm) for a COP nanocavity structure design 1 (R = 65 nm, H = 60 nm, d = 40 nm), a COP nanocavity structure design 2 (R = 115 nm, H = 100 nm, d = 30 nm) and compared with a bulk film of COP having the same thickness;

Figure 11 is a plot of the apparent contact angle for water with experimental points for COP nanocavities designs 1 and 2 and COP reference (all samples are coated with OPTOOL DSX®). Theoretical fit is obtained from the equation on section C;

Figure 12 represents plots of the apparent contact angle for linoleic acid with experimental points for COP nanocavities designs 1 and 2 and COP reference (all samples are coated with OPTOOL DSX®). Theoretical fit is adjusted for fitting the experimental data through the value of the trapped air layer (e = 70 nm);

Figure 13 is a plot of the apparent contact angle for water onto nanocavity structure (R = 115nm, H = 100nm) as a function of the solid fraction. Theoretical fit is obtained from the equation on section C with (ΔPmax) or without (ΔPmin) the contribution of an external pressure (of 4.5 $10^4$ Pa) applied on the drop ;

Figure 14 is a plot of the apparent contact angle for linoleic acid onto nanocavity structure (R = 115nm, H = 100nm) as a function of the solid fraction and with an additional air trapped layer (e=70nm). Theoretical fit is obtained from the equation on section C with (ΔPmax) or without (ΔPmin) the contribution of an external pressure (of 2.5 $10^4$ Pa) applied on the drop ;

Figure 15 represents the theoretical plot of sinking (α) in the case of a drop of a water applied onto a nanocavity structure (design 2) with an increasing applied pressure (ΔP) from 0 Pa up to 4.5 $10^4$ Pa.

Figure 16 represents a theoretical plot of sinking (α) in the case of a drop of linoleic acid applied onto a nanocavity structure with a pressure of 2.5 $10^4$ Pa corresponding to a strong fingerprinting pressure as a function of the cavity geometrical parameters: height H and radius R for a geometrical solid fraction $\varphi \approx 0.3$, and for an additional thin air layer (e = 70 nm);

Figures 17A and 17B are schematics of pillar structure with notations used in the calculation of breakthrough pressure in the case of rain conditions or impacted water drop.

Figure 18 represents plots of maximum water pressure (breakthrough pressure) that can be sustained by nanopillar structures having a diameter of 100nm and nanocavity structures as a function of geometrical solid function of the structure and compared with functional performances for rain conditions.

Figure 19 is a schematic of ball-type nanostructure or arranged nanoparticle surface with notations used in the calculation of breakthrough pressure in the case of fingerprint (based on equations developed by MIT)

Figure 20 represents plots of maximum linoleic acid pressure (breakthrough pressure) that can be sustained by nanoparticle structures having a diameter of 100nm and nanocavity structures as a function of geometrical solid function of the structure and compared with functional performances for fingerprint.

Figure 21 represents plots showing the evolution of the sinking (α) of oil (static contact angle 80°) as a function of the radius (R) and the height (H) of the cavities and for two different pressures applied onto the liquid using the theoretical model of WO-2011/106196 (Mazumder et al.) without any additional air trapped layer.

Figure 22 represent the selection of the thickness of air trapped layer as a function of the liquid viscosity to probe.

DETAILED DESCRIPTION AND EXAMPLES

A. Cavity structure description

The cavity size parameters are defined in Figure 1. Mainly, the studied structures are cylindrical shape, hexagonal arrangement, with height H, radius R and wall thickness d as defined in Fig. 3. Another important parameter to control is the geometrical solid fraction (φ) previously defined. The solid fraction controls the repellency level (value of apparent static contact angle θ*) and the height and radius control the wetting robustness properties. The impregnation of liquid inside the structure "sinking" is defined as function of the sinking parameter α = h/H (Fig. 2) (or α=h/Hx100, when α is expressed in percent).

The geometrical solid fraction can be calculated using the following formula:

$$\varphi = 1 - \frac{2\pi R^2}{\sqrt{3}(2R + d)^2}$$

where R and d are as defined above.

B. Theoretical prediction for sinking

The inventors developed a theoretical model based on Laplace law and Cassie-Baxter theory enabling the prediction of the sinking of the liquid inside the cavity ($\alpha$) when a pressure $\Delta P$ is applied as well as the resulting static contact angle of the liquid (apparent static contact angle). The equations are based on the equilibrium of the pressures on either side of the liquid/air interface inside the cavity as explain in the schematic views of Fig. 5A and Fig. 5B. From this equilibrium, one can extract the expression of the sinking ($\alpha$) as a function of the cavity size parameters, the wetting properties of the liquid on the solid fraction and the different pressures applied on the liquid drop.

The sinking ($\alpha$) is expressed as follows:

$$\alpha = \frac{\left(1 + \frac{R}{H} f(\theta_{adv})\right)\left(P_a + \frac{2\gamma\cos\theta_{adv}}{R}\right) - \frac{V_i}{V_0} P_0}{P_a + \frac{2\gamma\cos\theta_{adv}}{R}}$$

with

- Pa: hydrostatic pressure → $Pa = P_0 + \rho gz + \Delta P$
- $P_0$: atmospheric pressure
- $\rho gz$: pressure caused by gravity of the liquid drop
- $\Delta P$: external pressure applied onto the drop
- $\gamma$ : liquid surface tension
- R: radius of the cavity
- H: height of the cavity
- d: distance between two cavities
- $\theta_{adv}$: advancing angle of the liquid onto a flat surface
- $V_0$: geometrical volume of one cavity → $V_0 = \pi R^2 H$
- Vi: total volume of the cavity including the volume of air trapped by the liquid when this one contacts the surface

$$V_i = \pi R^2 H + e\frac{\sqrt{3}}{2}(2R + d)^2$$

- e: thickness of the air layer trapped by the liquid (schematic on Fig. 4 explained the phenomena)
- f($\theta$): coefficient → for cylindrical cavity: $f(\theta) = \frac{1 - \sin\theta}{6\cos\theta}\left[3 + \frac{(1 - \sin\theta)^2}{\cos\theta^2}\right]$

The liquid used for calculation according to the invention is linoleic acid, and pressure $\Delta P = 2.5\ 10^4$Pa (Fingerprint pressure).

Thickness of the air layer is determined using the Fig. 22. The thickness of air is determined in the case of nanostructure in the range [10nm - 70nm] depending on the viscosity of the liquid to be probed.

C. Theory predicting the apparent contact angle

The apparent contact angle (resulting static contact angle on the nanostructured surface $\theta^*$) is calculated from

the theory of Cassie-Baxter that has been modified for inducing the sinking and the meniscus curvature. The expression used is the following:

$$cos\theta^* = (\varphi + \varphi')cos\theta_{stat} - \varphi''$$

with

φ: geometric solid fraction:

$$\varphi = 1 - \frac{2\pi R^2}{\sqrt{3}(2R + d)^2}$$

φ': surface fraction corresponding to the sinking of the liquid into the cavity:

$$\varphi' = \frac{4\pi R\alpha H}{\sqrt{3}(2R + d)^2}$$

φ": surface fraction corresponding to the shape of the meniscus is

$$\varphi'' = \frac{4\pi \frac{R}{\cos\theta_{adv}} h_m}{\sqrt{3}(2R + d)^2}$$

and
$h_m$ is the height of the meniscus

$$h_m = R\frac{1 - sin\theta_{adv}}{|cos\theta_{adv}|}$$

$\theta^*$: apparent contact angle of the liquid on the textured surface
$\theta_{stat}$: static contact angle of the liquid on a flat surface (Fig. 2)
$\theta_{adv}$: advancing contact angle of the liquid on a flat surface (Fig. 2)
$\theta_{rec:}$ receding contact angle of the liquid on a flat surface (Fig. 2)
$\theta_{:}$ contact angle comprises between $\theta_{rec}$ and $\theta_{adv}$ (Fig. 2) and corresponding to the angle at the interface between the liquid-air phase and the solid part of the cavity wall at the equilibrium (Fig. 4 and Fig. 5, Fig. 6). This value is determined by the theoretical model.

D. Study as a function of the sinking: design of cavities at nanometer scale

1. FOR WATER WITHOUT ANY AIR TRAPPED LAYER

The above theoretical model has been computed and the value of the sinking was expressed as a function of the cavity size parameters. For water, it was considered that the pressure applied is in the case of heavy rain ($\Delta$Pmax = 4.5 $10^4$ Pa). No sinking of water drop was noticed as a function of applied pressure up to 4.5 $10^4$ Pa for nanocavity structure design 2 (Fig. 15) and as a result, no influence on the apparent static contact angle for water (Fig. 13).

2. FOR LINOLEIC ACID WITH AN AIR TRAPPED LAYER AT NANOMETER SCALE

Linoleic acid was used as a standard oily and non-polar liquid for the theoretical model and for experiments.

In the range of 5nm<R<250nm (nanometer scale), a similar simulation was made for linoleic acid with an air layer trapped by the liquid (Fig. 14). The behavior is different compared to water because of the contribution of the Laplace pressure, which acts to increase the sinking in the case of linoleic acid (it reduces it in case of water). By

comparison between the fitting model and our experimental results (see Fig. 9), it was assumed that a thin layer of air of around 70nm can be trapped by the linoleic acid drop.

A similar simulation has been made for linoleic acid (Fig. 21) using the theoretical model of WO-2011/106196 (Mazumder et al.) with pressures:

$$\Delta P_{MIN} = 0Pa$$

$$\Delta P_{MAX} = Pext\ (Pext = 2.5\ 10^4\ Pa\ \text{fingerprint load})$$

It clearly results from figure 21 that, based on the theoretical model of WO-2011/106196, it would be impossible to obtain low sinking ($\alpha$) with both low radius and low height of cavities in the nanoscale area, in particular sinking ($\alpha$) ≤ 50% for cavity radius (R) of 250 nm or less and cavity height (H) of 750 nm or less.

The theoretical model of the invention, considering that the model of WO-2011/106196 is inaccurate, and taking into account an intervening air layer for the modelization leads to a totally contrary conclusion, showing that low radius and height of cavities in the nanoscale area, in particular as selected in the present invention, would allow obtaining low sinking ($\alpha$) values.

3. EXPERIMENTAL RESULTS: EVALUATION OF THE LIQUID REPELLENCY PROPERTY THROUGH LIQUID STATIC CONTACT ANGLE MEASUREMENT

Periodical nanocavities using Nano Imprinting Lithography technique were fabricated. These nanostructures are made of COP (CycloOlefin Polymer) or OrmoStamp (Microresist Technology GmbH); both materials coated with fluorinated coating (Optool DSX from Daikin). Two different cavity nanostructures were fabricated. The radius of the first nanocavity structure (design 1) is R=65nm, the height H=60nm and the distance wall (d) between two cavities is 40nm (Figs. 8A and 9A). The radius of the second nanocavity structure (design 2) is R=115nm, the height H=100nm and the distance wall (d) between two cavities is 30nm (Figs. 8B and 9B).

Cycloolefin polymer (COP) nanocavities replica process was implemented using a thermal imprint unit SCIVAX X-200®. The specifications for the thermal imprint unit are:

Substrate size < 70mm

Heating temperature < 650°C

Maximum load: 10kN

Atmosphere: air or vacuum

The imprinting conditions for COP are given in Table I below

TABLE 1

| CYCLOOLEFIN POLYMER (COP) NANOCA VITIES IMPRINT CONDITIONS | |
|---|---|
| Substrate | COP |
| Tg | 138°C |
| Atmosphere | Air |
| Mold temperature | 170°C |
| Substrate temperature | 170°C |
| Pushing speed | 10μm/s |
| Molding pressure | 3.3MPa |
| Molding retention time | 300s |
| Mold release temperature | 120°C |
| Substrate release temperature | 120°C |

(continued)

| CYCLOOLEFIN POLYMER (COP) NANOCA VITIES IMPRINT CONDITIONS | |
|---|---|
| Release speed | 5μm/s |

Ormostamp® nanocavities replica process was implemented using a UV-curable imprint unit using Engineering System Co., Ltd. (ESCO, Japan) UV nanoimprinter (model EUN-4200). The specifications for the UV imprint unit are:

Substrate size : 4 inches (10.16 cm)
LED UV light with 375nm wavelength and a power of 2.5 mW/$cm^2$
Adjustable pressure (from 0.02 to 0.4 MPa)
Adjustable pushing and rising speed from 1 to 4 mm/s
Atmosphere: air

The imprinting conditions for Ormostamp® are given in Table 2 below

TABLE 2

| ORMOSTAMP® NANOCA VITIES IMPRINT CONDITIONS | |
|---|---|
| Substrate | Glass slide |
| Atmosphere | Air |
| Mold temperature | 25°C |
| Substrate temperature | 25°C |
| Pushing speed | 1mm/s |
| Molding pressure | 0.2MPa |
| UV power | 2.5 mW/$cm^2$ |
| Insolation time | 15mn |
| Release speed | 4mm/s |

Nanocavities coating was effected as follows:

- The fluorinated coating is a mixture of 3M fluorinated FC40® and Daikin OPTOOL DSX® (0.1% in mass of OPTOOL DSX®).
- A becher is filled with the coating solution
- The surface of the sample with the nanocavities is activated by a soft oxygen plasma treatment (50W, 30s)
- Using a dip-coater system, the sample is deep into the coating liquid with a speed of 5mm/s and then the sample is kept into the solution during 5mn and finally removed from the solution with a raising speed of 1mm/s.
- Thereafter the sample is placed in an oven at 60°C for 1 hour with 90%RH.

The static contact angle was measured on these structures for both water and linoleic acid using a contact anglemeter dispensing droplet (droplet volume of 2μL). The static contact angle is plotted on Figs 11 and 12 as a function of the geometric solid fraction φ (defined above) and the theoretical curve for apparent contact angle is calculated from equation above with no pressure applied on the liquid (based on the conditions of measurement of contact anglemeter).

For water, the measured static contact angle for nanocavities is in good agreement with the theoretical modeling curve (Fig. 11). For linoleic acid, the experimental data are in good agreement with theoretical curve through the adjustment of the value of the air trapped layer thickness (Fig. 12).

The omniphobicity property was clearly demonstrated as well as the air trapped layer by viscous oily liquid. Based on the theoretical prediction, it is possible to continue to improve the repellency by reduction of the solid fraction below 0.3.

Additionally, for achieving good omniphobicity, which is usually characterized by a static contact angle for water >145° and a static contact angle for oil such as linoleic acid >130°, a solid fraction $\varphi<0.3$ is requested.

This means that the distance between two cavities, d, is linked to the radius of the cavity, R, by the formula (in the case of rounded structure with hexagonal arrangement):

$$d \leq \left(\sqrt{\frac{2\pi}{0.7\sqrt{3}}} - 2\right)R$$

This means d<0.28R (for hexagonal arrangement with circular cavities)

If only mean omniphobic properties (static contact angle for water>130° and a static contact angle for oil such as linoleic acid>110°) are targeted, a solid fraction $\varphi$<0.5 is requested) and in such case d<0.7R (for hexagonal arrangement with circular cavities).

4. OPTICAL PROPERTIES OF NANOCAVITY STRUCTURE

Transmittance and front-scattering were measured for the COP nanocavity structures design 1 and design 2 and compared with bulk COP film with same thickness (Fig. 10). The average values of transmittance and front-scattering in the visible range are the following:

- Bulk film COP:

  T=91.3%
  Front scattering <0.5%

- Nanocavities (COP) design 1
  T=93.8%
  Front scattering <0.5%

- Nanocavities (COP) design 2
  T=94.5%
  Front scattering <0.5%

Improvement of the optical properties (2.5% average value for transmittance in the case of design 1 and 3.2% average value for design 2) in the case of nanocavity structure is observed compared to bulk film. This is due to an anti-reflective effect created by the nanocavity structure.

OBSERVATION OF THE SURFACE MORPHOLOGY

The surface morphologies of the films were observed by scanning probe microscope (SPM, Nanocute, SII Nano Technology - Hitachi High Tech, Japan). The sizes of the structures cavity radius (R), edge width (*d*), cavity height (*H*), were measured from these images using Nano Navi software.

5. COMPARISON OF THE RESISTANCE TO LIQUID PRESSURE BETWEEN PILLAR STRUCTURES, OVERHANG STRUCTURES AND CAVITY STRUCTURES

Comparison of the maximum liquid pressure (breakthrough pressure) that can be applied onto an overhang nanostructure (ball-like structure), pillar structure and cavity structure before the liquid totally impregnates the structure. The calculation of this pressure for cavity structure was obtained by our developed model through the estimation of the liquid curvature and the sinking height ($\alpha$) for both liquids: water and linoleic acid. In the case of "open structure", as the mechanism is a little bit different, we adapted the equations developed by MIT in their publication for our design (nanoball structure) and our chosen liquids (linoleic acid).

MIT equations for calculation of breakthrough pressure in the case of nanoparticle or ball-type structure (notations and schematic of the studied structure are given in Fig. 19)

$$P_{breakthrough} \approx \frac{P_{Ref}}{\frac{1}{H^*} + \frac{1}{T^*}} \qquad H^* = \frac{2r\, l_{cap}(1-\cos\theta)}{\left[D^2\left(1+\sqrt{D^*}\right)\right]} \qquad T^* = \left(\frac{l_{cap}}{D}\right)\left[\frac{\sin(\theta - \Psi_{min})}{1+\sqrt{D^*}}\right]$$

$$D^* = (r+D)/r \qquad P_{ref} = 2\,\frac{\gamma}{l_{cap}} \qquad l_{cap} = \sqrt{\frac{\gamma}{\rho\, g}}$$

$H^*$: corresponds to the Cassie-Baxter wetting regime collapse due to short structure height
$T^*$: corresponds to the Cassie-Baxter wetting regime collapse due to pressure induced de-pinning of the contact line
$\gamma$: liquid surface tension (for linoleic acid, $\gamma$= 33.4 mN/m)
$l_{cap}$: capillary length (for linoleic acid, $l_{cap}$ = 1.97mm)
$\theta$: contact angle of the liquid-air with the structure (see Fig. 19)
$\psi_{min}$: angle defined by the tangent to the ball and a plane parallel to the base plane at the lowest contact point of the liquid with the ball see (Fig. 19).

For rain condition, we use equation developed in the case of water drop impacting pillar structure (Equation (1) and Fig. 5 of the publication [Reyssat 2006]). If we are above the breakthrough pressure, the meniscus does not touch the bottom of the structure and if we are below it, a part of the drop will remain stick on the bottom of the structure (Fig.17).

$$P_{breakthrough} \approx 0.05 \frac{\gamma h}{l^2}$$

h : pillar height
l : separation distance between two pillars
$\gamma$: liquid surface tension (for water, $\gamma$= 72 mN/m)

[Reyssat 2006] M. Reyssat, A. Pepin, F. Marty, Y. Chen, and D. Quere, Bouncing transitions on microtextured materials, Europhys. Lett., 74 (2), pp. 306-312 (2006)

The values of pressure applied during rain and fingerprint have been calculated from the characteristics of rain and fingerprinting in the case of touch panels.

The calculated maximum pressure applied on the liquid that the structure is able to sustain is plotted as a function of solid fraction (controlling apparent static contact angle) and compared with conditions of fingerprint and rain conditions. It appears clearly that cavity structure exhibits much higher resistance to the pressure than "open structures" (Fig.18 and Fig. 20).

As a conclusion, the present invention proposes a structure designed for achieving omniphobicity based on the principle of air-trapped inside cavity. This kind of structure has also the advantage to be mechanically robust compared to open structure like overhang structure (ball, nails,...).

Additionally, the pressure inside the cavity offers a wetting robustness to the system. When applying strong pressure on the drops (mainly pressure applied by the velocity of heavy rain drop or fingerprinting step), the air remains trapped inside the cavity and offers resistance to impregnation by liquid.

For the nanocavity, the static contact angle was measured at 138° for water and 116° for linoleic acid in the case of first design and 145° for water and 128° for linoleic acid in the case of second design. These nanocavity structures also exhibit transparency (>94%) thanks to a very low front-scattering (<0.5%) and an anti-reflective effect (improvement of transmittance from 2.5% up to 3.2%).

The present invention which proposes a new modelization for determining sinking ($\alpha$) of a liquid under pressure as a function of the cavity parameters of a cell nanostructured structure in the nanometer scale, taking into account the presence of an air layer, totally reverses the conclusions that could have been drawn by a skilled person from the prior art modelization and results.

## Claims

1. A manufactured article comprising at least one nanostructured surface, wherein:

   - said nanostructured surface is made of a material having a surface energy of less than 25 mJ/m$^2$, preferably less than 20 mJ/m$^2$, and comprises an array of contiguous cells defining cavities,
   the cavities of the cells being separated from each other by intermediate solid material walls, and opened to the environment
   and
   - the cavities have an average height (H) and an average radius (R) which meet the conditions:

     R $\geq$ 5 nm, preferably R $\geq$ 10 nm;
     R $\leq$ 250 nm, preferably R $\leq$ 200 nm, better R $\leq$ 150 nm and more preferably R $\leq$ 100 nm; and

$H \leq 3R$.

**2.** The manufactured article of claim 1 having a sinking ($\alpha$) equal to or lower than 50%, wherein

$$\alpha(\%) = \frac{h}{H} 100$$

where h is the wetting height by a liquid of the cavity intermediate wall and H is the average height of the cavity.

**3.** The manufactured article of claim 2, wherein sinking ($\alpha$) is from 10% to less than 30% and cavity average height H meets the condition $H \leq 1.5\,R$.

**4.** The manufactured article of claim 2, wherein sinking ($\alpha$) is less than 10% and cavity average height H meets the condition $H \leq 0.5R$.

**5.** The manufactured article of claims 1 to 4, wherein $H > 0.20\,R$

**6.** The manufactured article according to anyone of claims 1 to 5, wherein the geometrical solid fraction ($\varphi$) of the cell array is equal to or lower than 0.7, preferably equal to or lower than 0.5, and preferably equal to or lower than 0.3, the geometrical solid fraction ($\varphi$) being defined as from nanostructure top view perspective as the ratio of the solid surface area to the total surface area of the nanostructured surface.

**7.** The manufactured article according to anyone of claims 1 to 6, wherein the array is a periodical array.

**8.** The manufactured article according to anyone of claims 1 to 7, wherein the nanocavities are cylindrical.

**9.** The manufactured article according to anyone of claims 1 to 8, wherein the nanostructured surface has been submitted to a hydrophobic and/or oleophobic treatment.

**10.** The manufactured article of claim 9, wherein the hydrophobic and/or oleophobic treatment consists in depositing a hydrophobic and/or oleophobic coating on the manufactured surface.

**11.** The manufactured article of claim 10, wherein the hydrophobic and/or oleophobic coating comprises fluorinated compounds.

**12.** The manufactured article according to anyone of claims 1 to 11, wherein the manufactured article is a transparent article.

**13.** The manufactured article of claim 12, wherein the transparent article is an optical article, preferably an ophthalmic lens.

**14.** The manufactured article of claims 2 to 12, wherein sinking is determined by the following measurement methods: freezing the liquid or hardening the fluid while keeping the same surface tension for the fluid as the liquid to probe and measure the sinking by checking the shape of the solidified liquid by SEM (scanning electron microscopy).

**15.** The manufactured article of claim 2 to 12, wherein sinking ($\alpha$) is calculated using the theoretical model:

$$\alpha = \frac{\left(1 + \frac{R}{H} f(\theta_{adv})\right)\left(P_a + \frac{2\gamma\cos\theta_{adv}}{R}\right) - \frac{V_i}{V_0} P_0}{P_a + \frac{2\gamma\cos\theta_{adv}}{R}}$$

with

$\gamma$: liquid surface tension

Pa : hydrostatic pressure → $Pa = P_0 + \rho gz + \Delta P$
$P_0$ : atmospheric pressure
$\rho gz$ : pressure caused by gravity of the liquid drop
$\Delta P$ : external pressure applied onto the drop
R: average radius of the cavity
H : average height of the cavity
d : average distance between two cavities
$\theta_{adv}$ : advancing angle of the liquid onto a flat surface, made of the same materials
$V_0$: geometrical volume of one cavity → $V_0 = \pi R^2 H$
Vi: total volume of the cavity including the volume of air trapped by the liquid when this one contacts the surface

$$\rightarrow Vi = \pi R^2 H + e\frac{\sqrt{3}}{2}(2R+d)^2$$

e: thickness of the air layer trapped by the liquid

f(θ): coefficient → for cylindrical cavity : $f(\theta) = \frac{1-\sin\theta}{6\cos\theta}\left[3 + \frac{(1-\sin\theta)^2}{\cos\theta^2}\right]$ wherein liquid is linoleic acid and $\Delta P = 2.5\ 10^4$Pa, and wherein, in the case the cavities have wall side profile forming an angle β (different than 90°) with an horizontal plane of the nanostructured surface $\theta_{adv}$ is replaced by ($\theta_{adv} + \pi/2 - \beta$).

**16.** A method for designing a nanostructured surface comprising an array of juxtaposed cells defining cavities separated from each other by solid intermediate walls, said method comprising:

- obtaining a map of areas of different values of the sinking (α) as a function of the radius (R) and the height (H) of the cavities, said values of the sinking (α) being calculated using the theoretical model as in claim 15
- selecting values of radius (R) and height (H) for the cavities according to a desired sinking value; and
- forming the cell array with the selected values for the radius (R) and height (H) of the cavities.

**Patentansprüche**

**1.** Fertigungsgegenstand, umfassend wenigstens eine nanostrukturierte Oberfläche, wobei:

- die nanostrukturierte Oberfläche aus einem Material mit einer Oberflächenenergie von kleiner als 25 mJ/m$^2$, vorzugsweise kleiner als 20 mJ/m$^2$, besteht und eine Anordnung von zusammenhängenden Zellen, die Hohlräume definieren, umfasst,
die Hohlräume der Zellen durch Zwischenwände aus festem Material voneinander getrennt und gegenüber der Umgebung offen sind,
und
- die Hohlräume eine mittlere Höhe (H) und einen mittleren Radius (R) aufweisen, die den Bedingungen entsprechen:

$R \geq 5$ nm, vorzugsweise $R \geq 10$ nm;
$R \leq 250$ nm, vorzugsweise $R \leq 200$ nm, besser
$R \leq 150$ nm und bevorzugter $R \leq 100$ nm; und
$H \leq 3$ R.

**2.** Fertigungsgegenstand gemäß Anspruch 1 mit einer Absenkung (α) von gleich oder kleiner als 50 %, wobei

$$\alpha(\%) = \frac{h}{H}100$$

wobei h die Benetzungshöhe der Hohlraum-Zwischenwand durch eine Flüssigkeit ist und H die mittlere Höhe des Hohlraums ist.

3. Fertigungsgegenstand gemäß Anspruch 2, wobei die Absenkung ($\alpha$) von 10 % bis weniger als 30 % beträgt und die mittlere Hohlraumhöhe H der Bedingung $H \leq 1{,}5\ R$ entspricht.

4. Fertigungsgegenstand gemäß Anspruch 2, wobei die Absenkung ($\alpha$) kleiner als 10 % ist und die mittlere Hohlraumhöhe H der Bedingung $H \leq 0{,}5\ R$ entspricht.

5. Fertigungsgegenstand gemäß Ansprüchen 1 bis 4, wobei $H > 0{,}20\ R$.

6. Fertigungsgegenstand gemäß einem der Ansprüche 1 bis 5, wobei der geometrische Festmaterialanteil ($\varphi$) der Zellenanordnung gleich oder kleiner als 0,7, vorzugsweise gleich oder kleiner als 0,5 und vorzugsweise gleich oder kleiner als 0,3 ist, wobei der geometrische Festmaterialanteil ($\varphi$) in der Perspektive einer Draufsicht auf die Nanostruktur als das Verhältnis der Festmaterialoberfläche zu der Gesamtfläche der nanostrukturierten Oberfläche definiert ist.

7. Fertigungsgegenstand gemäß einem der Ansprüche 1 bis 6, wobei die Anordnung eine periodische Anordnung ist.

8. Fertigungsgegenstand gemäß einem der Ansprüche 1 bis 7, wobei die Nanohohlräume zylindrisch sind.

9. Fertigungsgegenstand gemäß einem der Ansprüche 1 bis 8, wobei die nanostrukturierte Oberfläche einer hydrophoben und/oder oleophoben Behandlung unterzogen worden ist.

10. Fertigungsgegenstand gemäß Anspruch 9, wobei die hydrophobe und/oder oleophobe Behandlung aus dem Aufbringen einer hydrophoben und/oder oleophoben Beschichtung auf die gefertigte Oberfläche besteht.

11. Fertigungsgegenstand gemäß Anspruch 10, wobei die hydrophobe und/oder oleophobe Beschichtung fluorierte Verbindungen umfasst.

12. Fertigungsgegenstand gemäß einem der Ansprüche 1 bis 11, wobei der Fertigungsgegenstand ein transparenter Gegenstand ist.

13. Fertigungsgegenstand gemäß Anspruch 12, wobei der transparente Gegenstand ein optischer Gegenstand, vorzugsweise eine ophthalmische Linse, ist.

14. Fertigungsgegenstand gemäß einem der Ansprüche 2 bis 12, wobei die Absenkung durch die folgenden Messverfahren bestimmt wird: Einfrieren der Flüssigkeit oder Härten des Fluids unter Bewahrung der gleichen Oberflächenspannung für das Fluid wie bei der Flüssigkeit zum Prüfen und Messen der Absenkung durch Überprüfen der Form der erstarrten Flüssigkeit durch REM (Rasterelektronenmikroskopie).

15. Fertigungsgegenstand gemäß Anspruch 2 bis 12, wobei die Absenkung ($\alpha$) unter Verwendung des theoretischen Modells:

$$\alpha = \frac{\left(1 + \frac{R}{H} f(\theta_{adv})\right)\left(P_a + \frac{2\gamma\cos\theta_{adv}}{R}\right) - \frac{V_i}{V_0} P_0}{P_a + \frac{2\gamma\cos\theta_{adv}}{R}}$$

berechnet wird, wobei

$\gamma$: Oberflächenspannung der Flüssigkeit
Pa: hydrostatischer Druck $\rightarrow Pa = P_0 + \rho gz + \Delta P$
$P_0$: atmosphärischer Druck
$\rho gz$: durch Schwerkraft des Flüssigkeitstropfens erzeugter Druck
$\Delta P$: an dem Tropfen anliegender externer Druck
R: mittlerer Radius des Hohlraums
H: mittlere Höhe des Hohlraums
d: mittlerer Abstand zwischen zwei Hohlräumen
$\theta_{adv}$: Fortschreitwinkel der Flüssigkeit auf einer flachen Oberfläche, die aus den gleichen Materialien hergestellt

ist
$V_0$: geometrisches Volumen eines Hohlraums → $V_0 = \pi R^2 H$
$V_i$: Gesamtvolumen des Hohlraums, einschließlich des Volumens von Luft, das von der Flüssigkeit eingeschlossen wird, wenn diese mit der Oberfläche in Kontakt kommt,

$$\rightarrow Vi = \pi R^2 H + e\frac{\sqrt{3}}{2}(2R + d)^2$$

e: Dicke der von der Flüssigkeit eingeschlossenen Luftschicht
f(θ) : Koeffizient → für zylindrischen Hohlraum:

$$f(\theta) = \frac{1 - \sin\theta}{6\cos\theta}\left[3 + \frac{(1 - \sin\theta)^2}{\cos\theta^2}\right]$$

wobei die Flüssigkeit Linolsäure ist und $\Delta P = 2{,}5\ 10^4$ Pa, und wobei in dem Fall, dass die Hohlräume ein Wandseitenprofil aufweisen, das einen Winkel β (von 90° verschieden) mit einer waagrechten Ebene der nanostrukturierten Oberfläche bildet, $\theta_{adv}$ durch ($\theta_{adv} + \pi/2 - \beta$) ersetzt wird.

**16.** Verfahren zum Entwerfen einer nanostrukturierten Oberfläche, die ein Feld von nebeneinanderliegenden Zellen umfasst, die durch feste Zwischenwände voneinander getrennte Hohlräume definieren, wobei das Verfahren umfasst:

- Erhalten einer Zuordnung von Bereichen verschiedener Werte der Absenkung (α) als Funktion des Radius (R) und der Höhe (H) der Hohlräume, wobei die Werte der Absenkung (α) unter Verwendung des theoretischen Modells wie in Anspruch 15 berechnet werden;
- Auswählen von Werten von Radius (R) und Höhe (H) für die Hohlräume, die einem gewünschten Wert der Absenkung entsprechen; und
- Bilden der Zellenanordnung mit den ausgewählten Werten für den Radius (R) und die Höhe (H) der Hohlräume.

## Revendications

**1.** Article manufacturé comprenant au moins une surface nanostructurée, dans lequel :

- ladite surface nanostructurée est constituée d'un matériau ayant une énergie de surface de moins de 25 mJ/m², de préférence moins de 20 mJ/m², et comprend un réseau de cellules contiguës définissant des cavités, les cavités des cellules étant séparées les unes des autres par des parois de matériau solide intermédiaires, et ouvertes à l'environnement
et
- les cavités ont une hauteur moyenne (*H*) et un rayon moyen (*R*) qui respectent les conditions :

$R \geq 5$ nm, de préférence $R \geq 10$ nm ;
$R \leq 250$ nm, de préférence $R \leq 200$ nm, mieux $R \leq 150$ nm, et mieux encore $R \leq 100$ nm ; et
$H \leq 3R$.

**2.** Article manufacturé de la revendication 1 ayant un enfoncement ($\alpha$) égal ou inférieur à 50 %, dans lequel

$$\alpha(\%) = \frac{h}{H}100$$

où *h* est la hauteur de mouillage par un liquide de la paroi intermédiaire de cavité et *H* est la hauteur moyenne de la cavité.

**3.** Article manufacturé de la revendication 2, dans lequel l'enfoncement ($\alpha$) va de 10 % à moins de 30 % et la hauteur

moyenne de cavité $H$ respecte la condition $H \leq 1{,}5R$.

4. Article manufacturé de la revendication 2, dans lequel l'enfoncement ($\alpha$) est inférieur à 10 % et la hauteur moyenne de cavité $H$ respecte la condition $H \leq 0{,}5R$.

5. Article manufacturé des revendications 1 à 4, dans lequel $H > 0{,}20R$.

6. Article manufacturé selon l'une quelconque des revendications 1 à 5, dans lequel la fraction solide géométrique ($\varphi$) du réseau de cellules est égale ou inférieure à 0,7, de préférence égale ou inférieure à 0,5, et de préférence égale ou inférieure à 0,3, la fraction solide géométrique ($\varphi$) étant définie dans une vue en perspective de dessus de la nanostructure comme le rapport entre la superficie solide et la superficie totale de la surface nanostructurée.

7. Article manufacturé selon l'une quelconque des revendications 1 à 6, dans lequel le réseau est un réseau périodique.

8. Article manufacturé selon l'une quelconque des revendications 1 à 7, dans lequel les nanocavités sont cylindriques.

9. Article manufacturé selon l'une quelconque des revendications 1 à 8, dans lequel la surface nanostructurée a été soumise à un traitement hydrophobe et/ou oléophobe.

10. Article manufacturé de la revendication 9, dans lequel le traitement hydrophobe et/ou oléophobe consiste à déposer un revêtement hydrophobe et/ou oléophobe sur la surface manufacturée.

11. Article manufacturé de la revendication 10, dans lequel le revêtement hydrophobe et/ou oléophobe comprend des composés fluorés.

12. Article manufacturé selon l'une quelconque des revendications 1 à 11, l'article manufacturé étant un article transparent.

13. Article manufacturé de la revendication 12, l'article transparent étant un article optique, de préférence un verre ophtalmique.

14. Article manufacturé des revendications 2 à 12, dans lequel l'enfoncement est déterminé par les méthodes de mesures suivantes : congeler le liquide ou durcir le fluide tout en maintenant la même tension superficielle pour le fluide et le liquide pour sonder et mesurer l'enfoncement en vérifiant la forme du liquide solidifié par MEB (microscopie électronique à balayage).

15. Article manufacturé des revendications 2 à 12, dans lequel l'enfoncement ($\alpha$) est calculé au moyen du modèle théorique :

$$\alpha = \frac{\left(1 + \frac{R}{H} f(\theta_{adv})\right)\left(P_a + \frac{2\gamma cos\theta_{adv}}{R}\right) - \frac{V_i}{V_0} P_0}{P_a + \frac{2\gamma cos\theta_{adv}}{R}}$$

avec

$\gamma$ : tension superficielle du liquide
$P_a$ : pression hydrostatique $\rightarrow P_a = P_0 + \rho gz + \Delta P$
$P_0$ : pression atmosphérique
$\rho gz$ : pression causée par la gravité de la goutte de liquide
$\Delta P$ : pression externe appliquée sur la goutte
$R$ : rayon moyen de la cavité
$H$ : hauteur moyenne de la cavité
$d$ : distance moyenne entre deux cavités
$\theta_{adv}$ : angle d'avance du liquide sur une surface plate, constituée des mêmes matériaux
$V_0$ : volume géométrique d'une cavité $\rightarrow V_0 = \pi R^2 H$

$V_i$ : volume total de la cavité incluant le volume d'air piégé par le liquide lorsque celui-ci est en contact avec la surface

$$\rightarrow V_i = \pi R^2 H + e\frac{\sqrt{3}}{2}(2R + d)^2$$

$e$ : épaisseur de la couche d'air piégée par le liquide
$f(\theta)$ : coefficient $\rightarrow$ pour une cavité cylindrique :

$$f(\theta) = \frac{1 - sin\theta}{6cos\theta}\left[3 + \frac{(1 - sin\theta)^2}{cos\theta^2}\right]$$

dans lequel le liquide est l'acide linoléique et $\Delta P$ = 2,5.10$^4$ Pa, et dans lequel, dans le cas où les cavités ont un profil de paroi latérale formant un angle $\beta$ (différent de 90°) avec un plan horizontal de la surface nanostructurée, $\theta_{adv}$ est remplacé par ($\theta_{adv}$ + $\pi$/2 - $\beta$).

**16.** Procédé de conception d'une surface nanostructurée comprenant un réseau de cellules juxtaposées définissant des cavités séparées les unes des autres par des parois intermédiaires solides, ledit procédé comprenant :

- l'obtention d'une carte de zones de différentes valeurs de l'enfoncement ($\alpha$) en fonction du rayon ($R$) et de la hauteur ($H$) des cavités, lesdites valeurs de l'enfoncement ($\alpha$) étant calculées au moyen du modèle théorique selon la revendication 15 ;
- la sélection de valeurs du rayon ($R$) et de la hauteur ($H$) pour les cavités en fonction d'une valeur d'enfoncement souhaitée ; et
- la formation du réseau de cellules avec les valeurs sélectionnées pour le rayon ($R$) et la hauteur ($H$) des cavités.

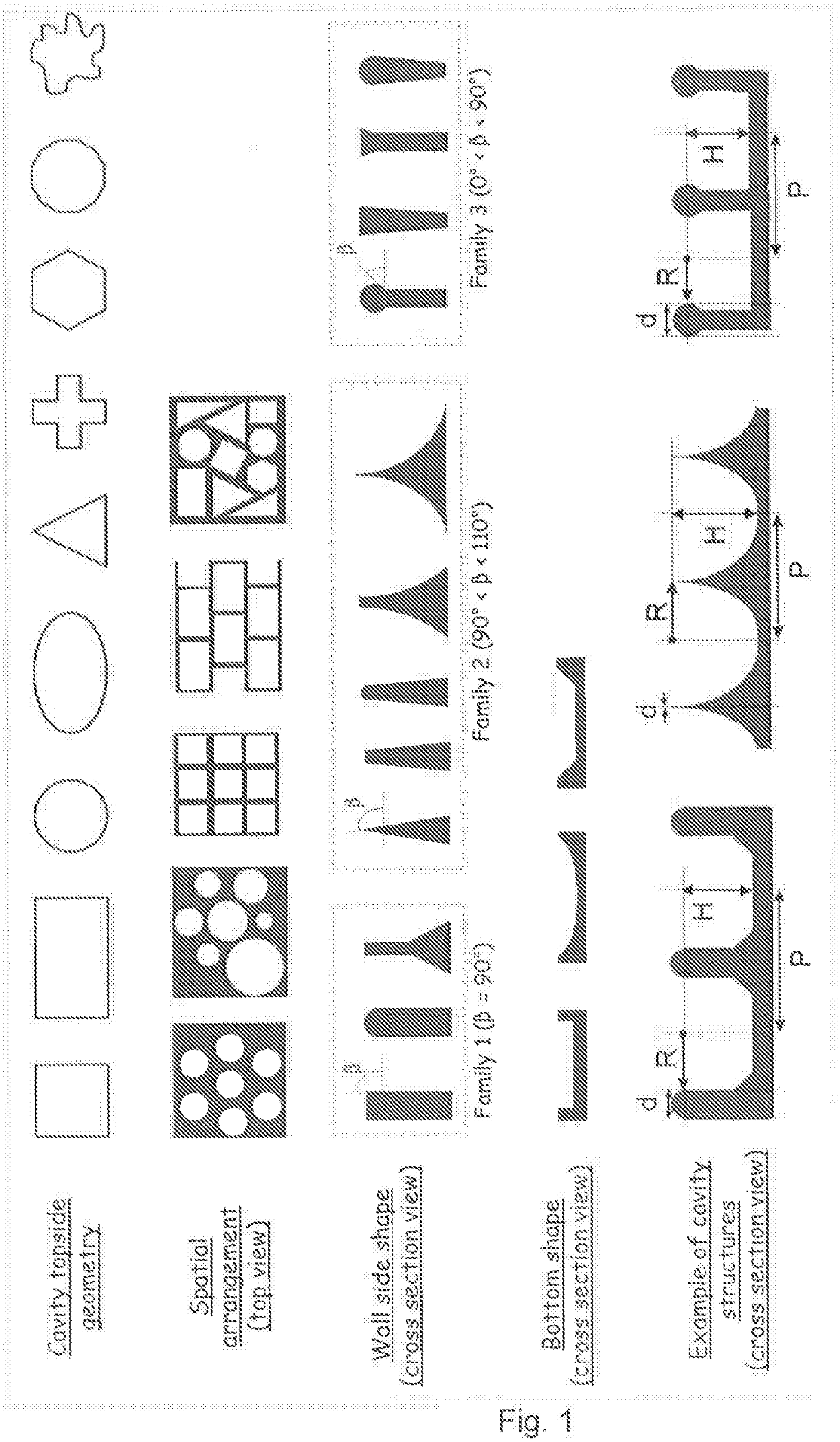
Cavity topside geometry
Spatial arrangement (top view)
Wall side shape (cross section view)
Bottom shape (cross section view)
Example of cavity structures (cross section view)
Family 1 (β = 90°)
Family 2 (90° < β < 110°)
Family 3 (0° < β < 90°)
β
d
R
H
P

Fig. 1

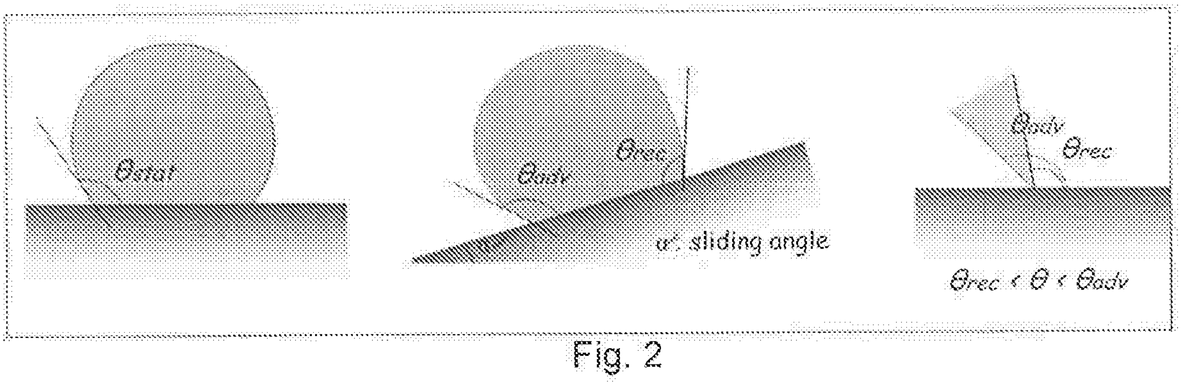


Fig. 2

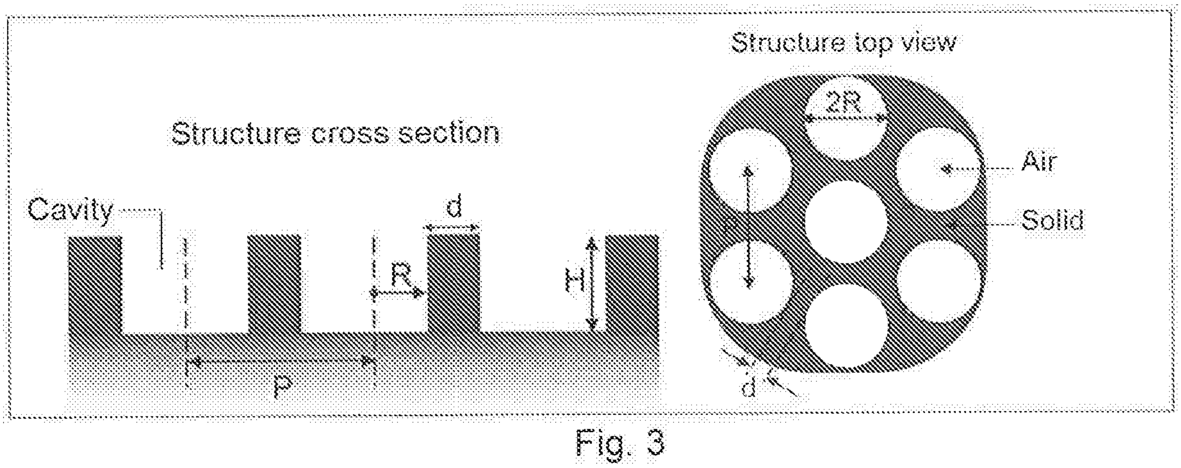


Fig. 3

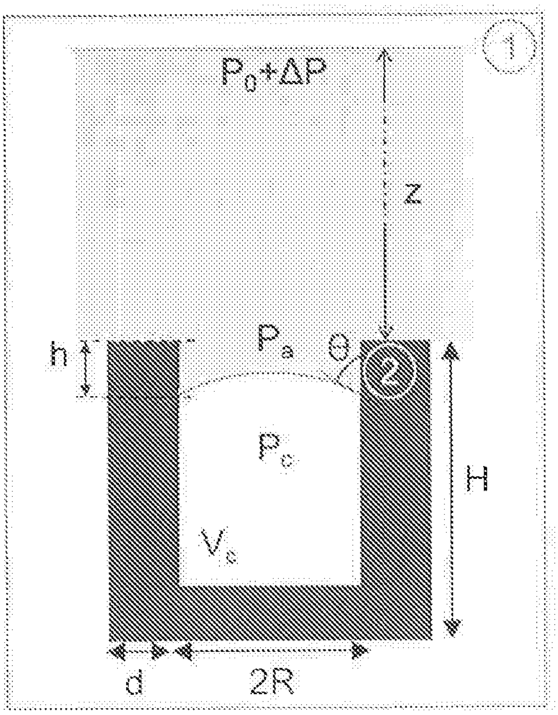


Fig. 4

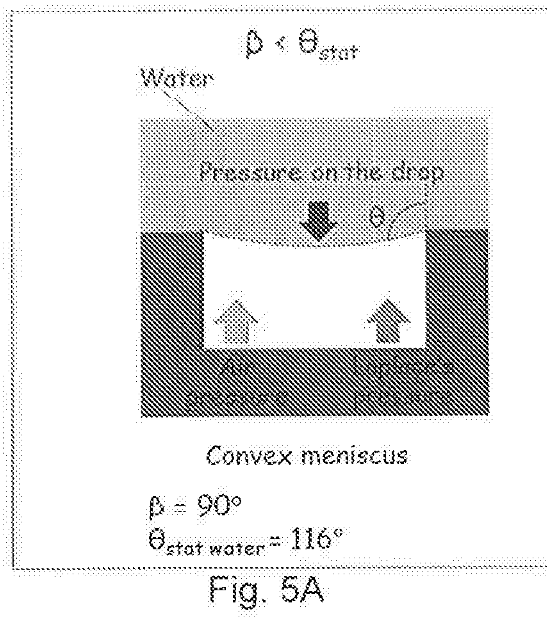


Fig. 5A

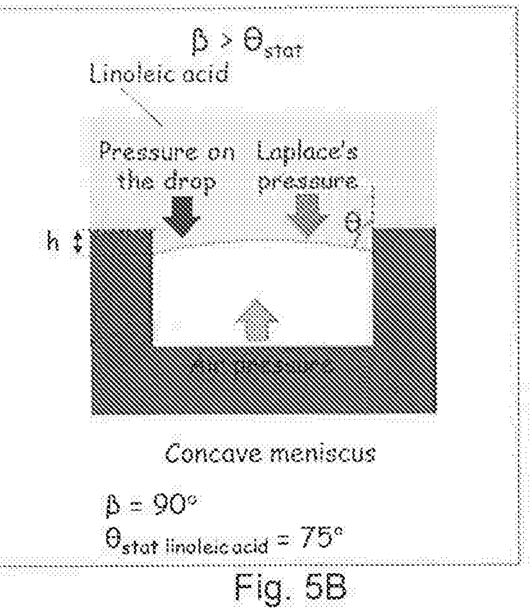


Fig. 5B

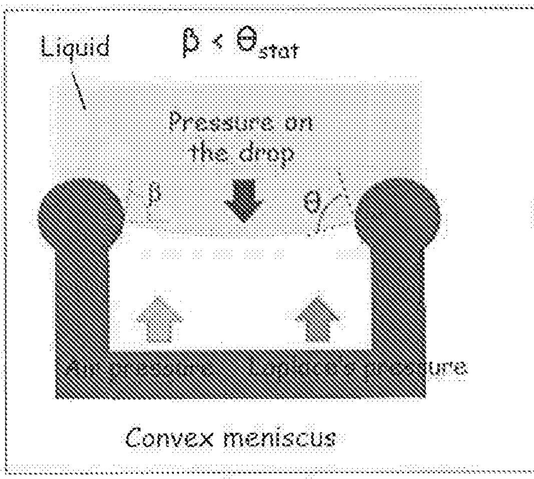


Fig. 6A

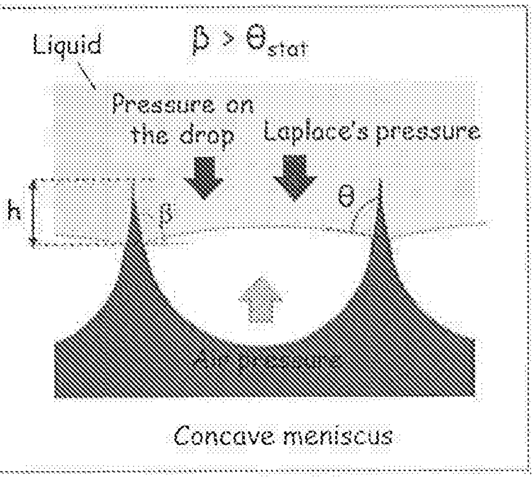


Fig. 6B

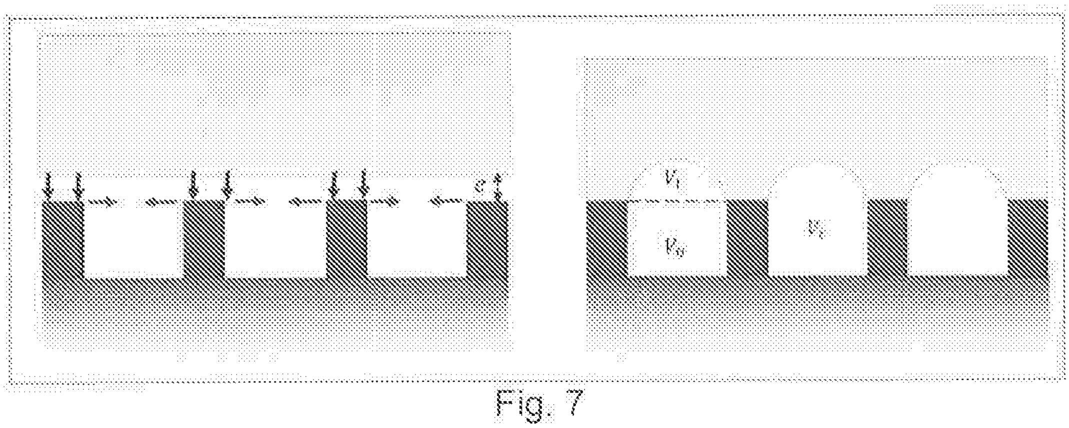


Fig. 7

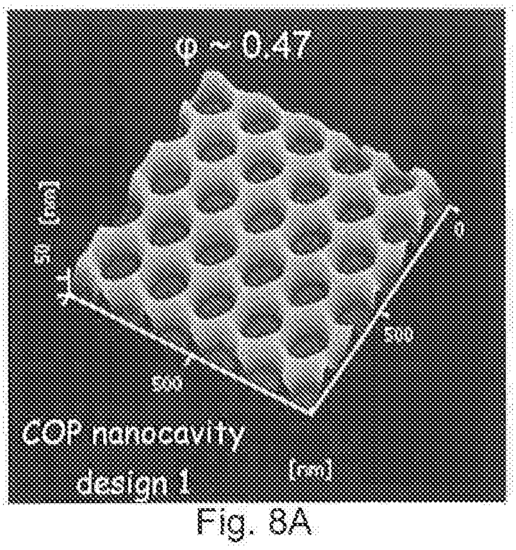


Fig. 8A

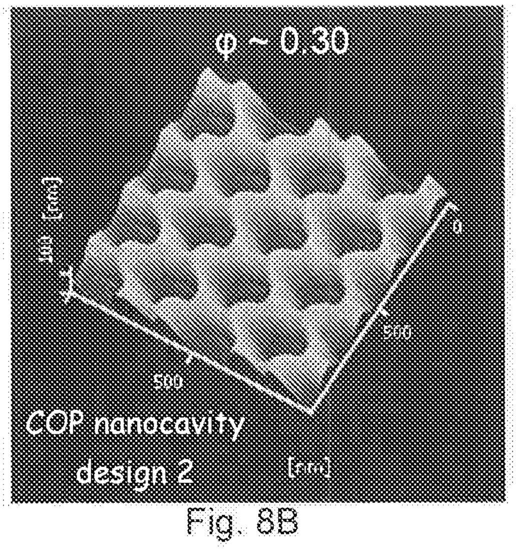


Fig. 8B

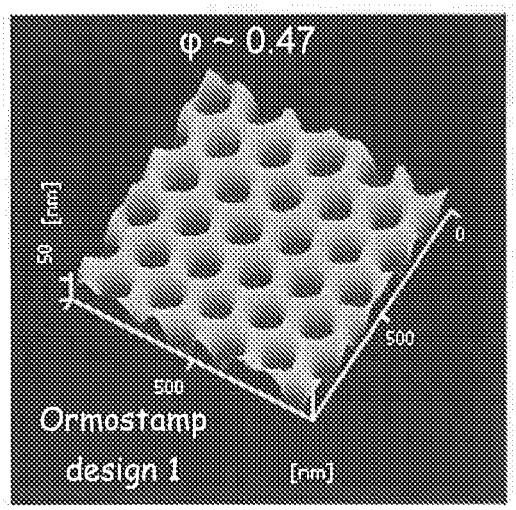


Fig. 9A

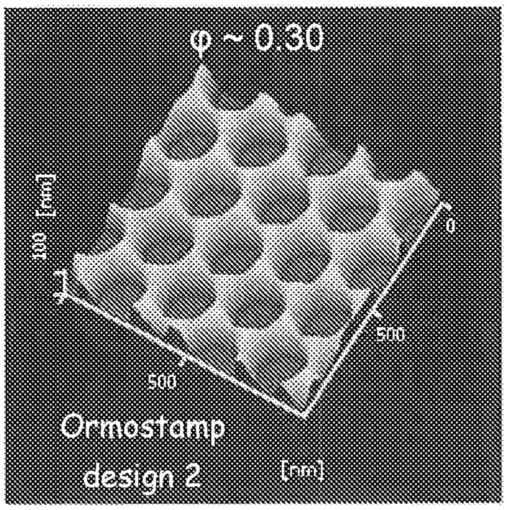


Fig. 9B

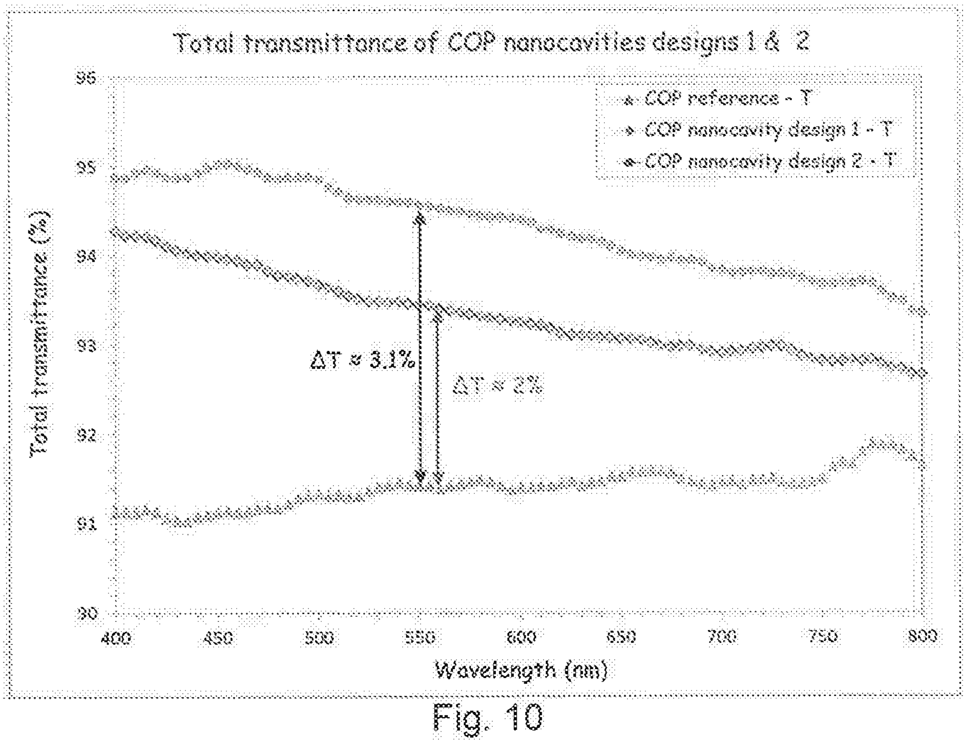
Total transmittance of COP nanocavities designs 1 & 2
COP reference - T
COP nanocavity design 1 - T
COP nanocavity design 2 - T
Total transmittance (%)
96
95
94
93
92
91
90
ΔT ≈ 3.1%
ΔT ≈ 2%
400
450
500
550
600
650
700
750
800
Wavelength (nm)

Fig. 10

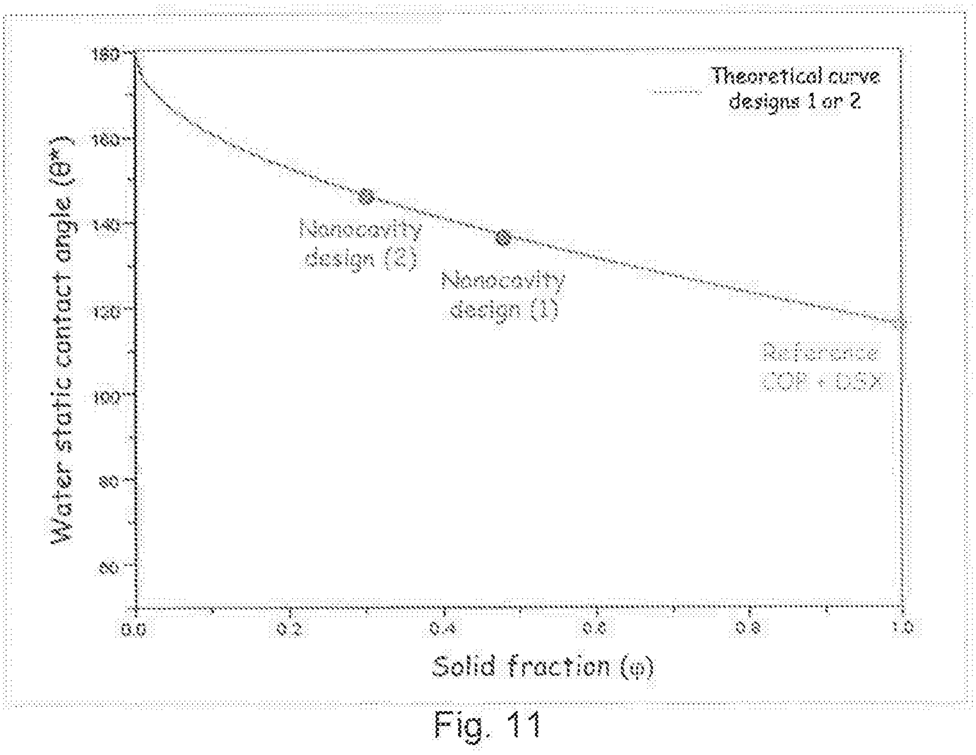
Theoretical curve
designs 1 or 2
Water static contact angle (θ*)
180
160
140
120
100
80
60
Nanocavity
design (2)
Nanocavity
design (1)
Reference
COP + DSX
0.0
0.2
0.4
0.6
0.8
1.0
Solid fraction (φ)

Fig. 11

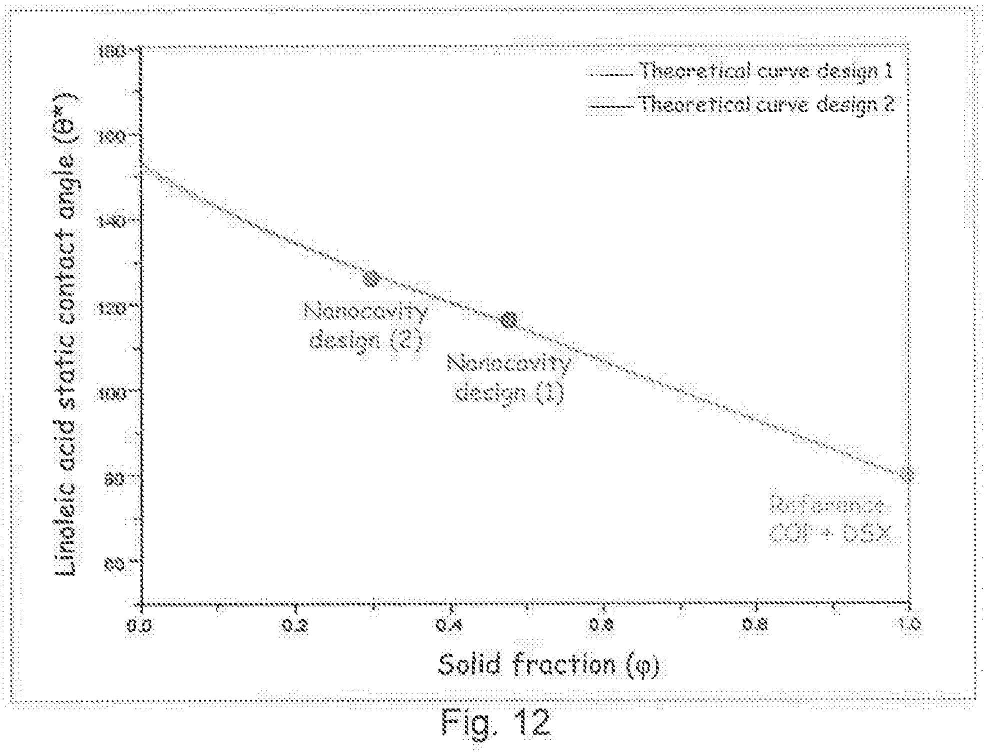
Theoretical curve design 1
Theoretical curve design 2
Linoleic acid static contact angle (θ*)
Nanocavity design (2)
Nanocavity design (1)
Reference COP + DSX
Solid fraction (φ)

Fig. 12

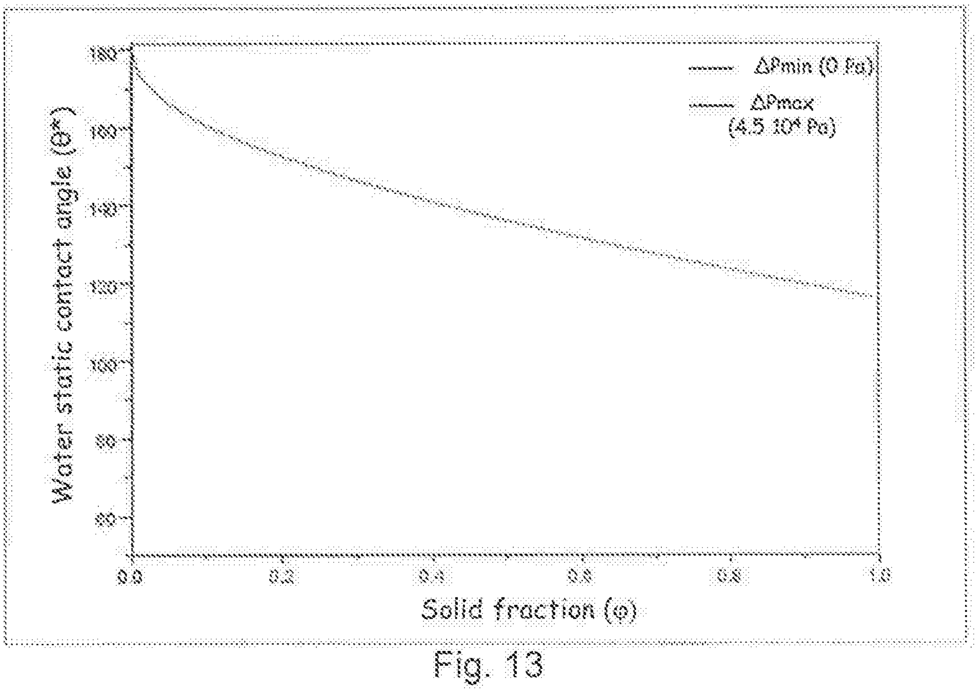
ΔPmin (0 Pa)
ΔPmax (4.5 10⁴ Pa)
Water static contact angle (θ*)
Solid fraction (φ)

Fig. 13

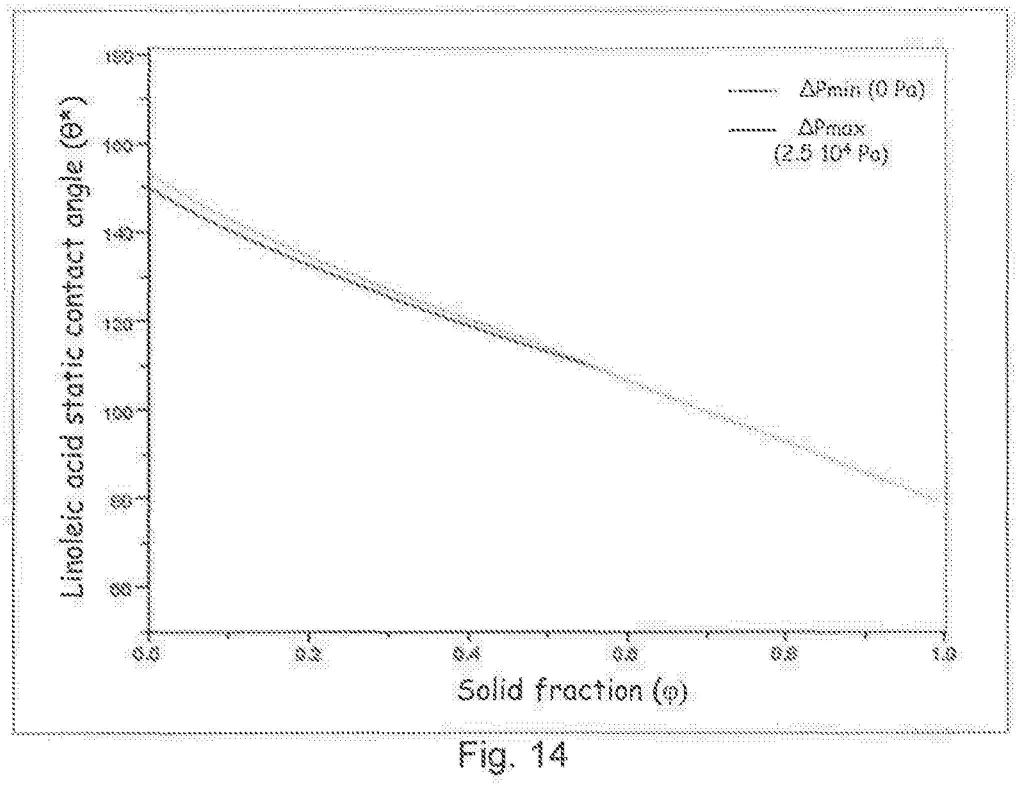
ΔPmin (0 Pa)
ΔPmax
(2.5 10⁴ Pa)
Linoleic acid static contact angle (θ*)
Solid fraction (φ)

Fig. 14

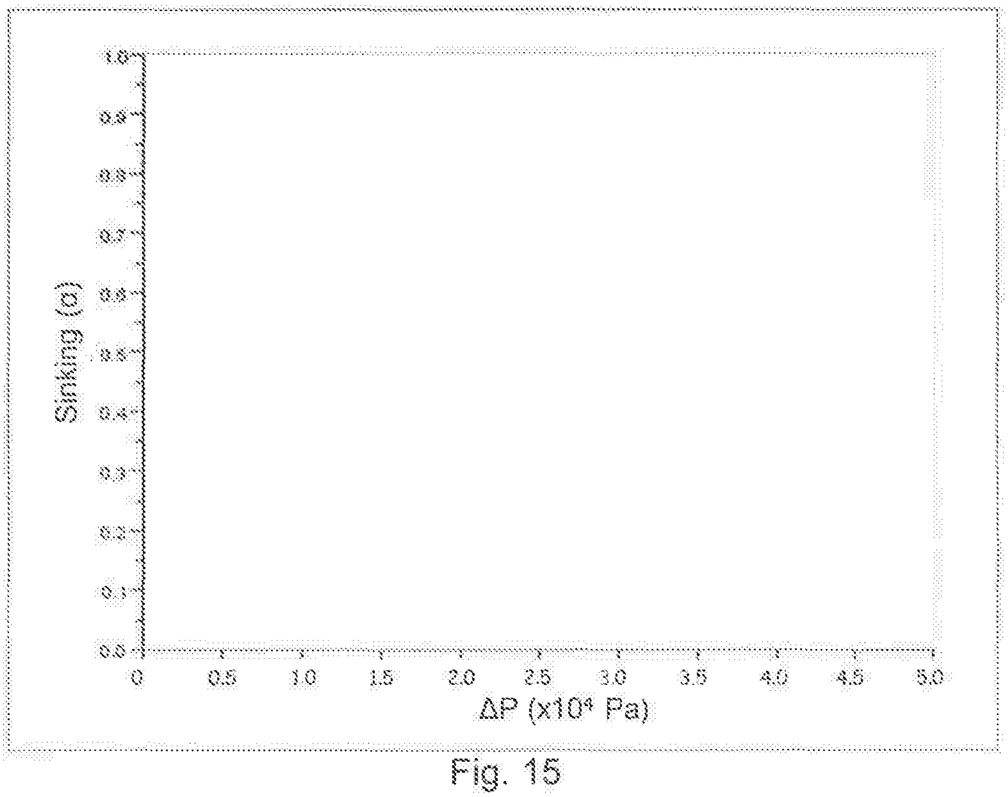
Sinking (α)
ΔP (x10⁴ Pa)
0
0.5
1.0
1.5
2.0
2.5
3.0
3.5
4.0
4.5
5.0

Fig. 15

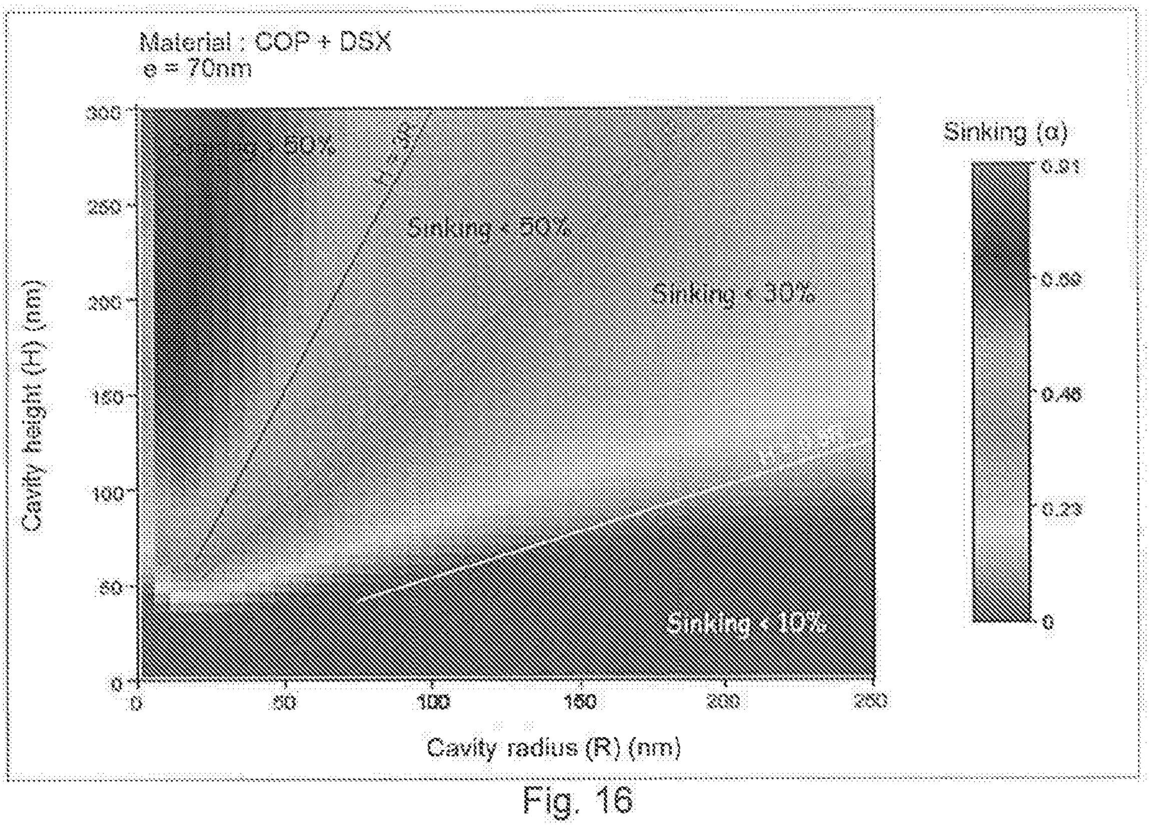


Fig. 16

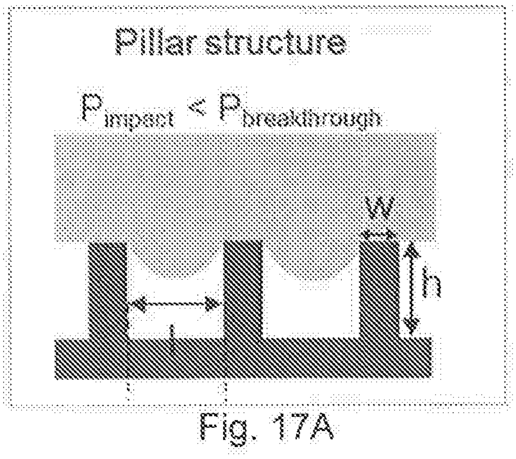


Fig. 17A

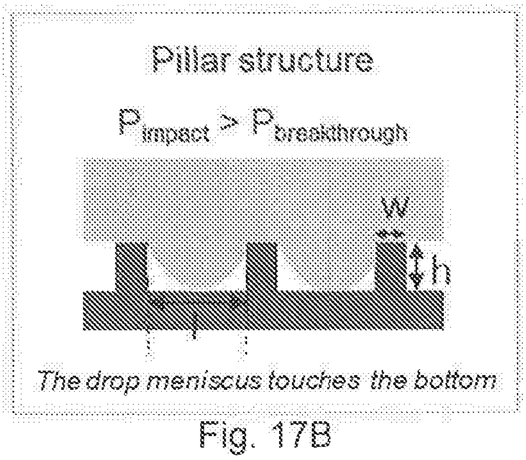


Fig. 17B

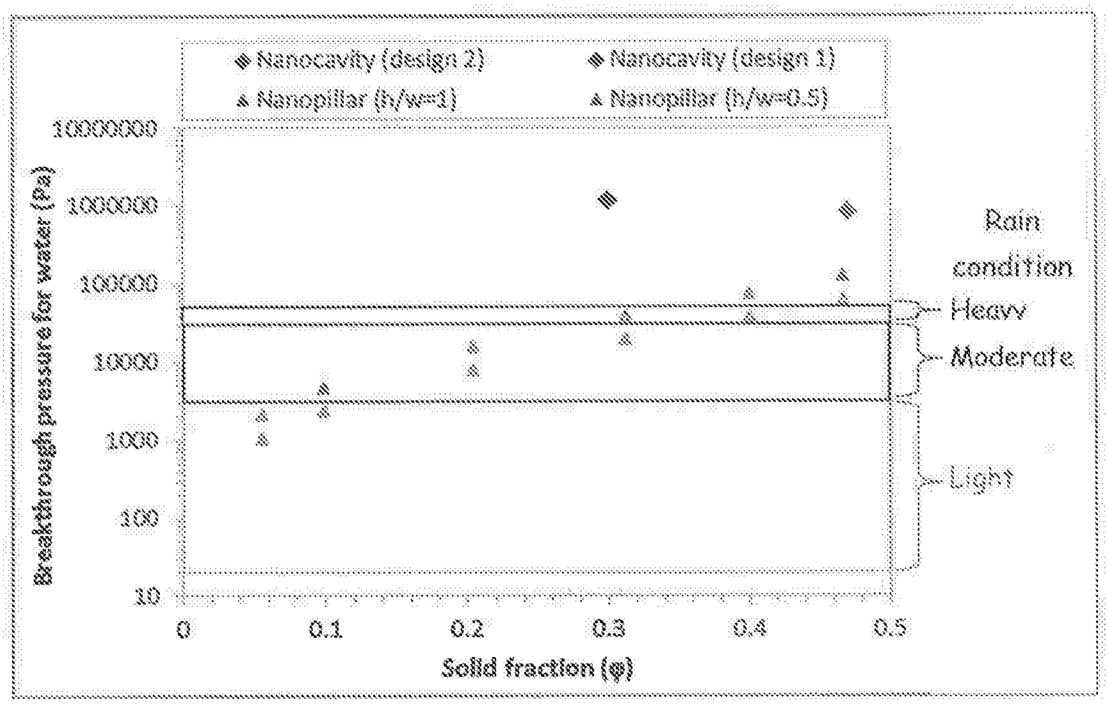
Nanocavity (design 2)
Nanocavity (design 1)
Nanopillar (h/w=1)
Nanopillar (h/w=0.5)
Breakthrough pressure for water (Pa)
10000000
1000000
100000
10000
1000
100
10
0
0.1
0.2
0.3
0.4
0.5
Solid fraction (φ)
Rain condition
Heavy
Moderate
Light

Fig. 18

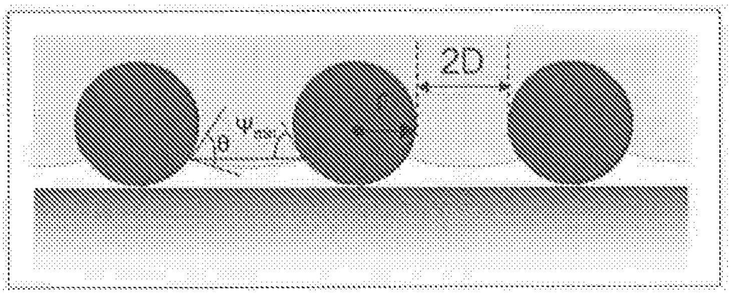
2D
θ

Fig. 19

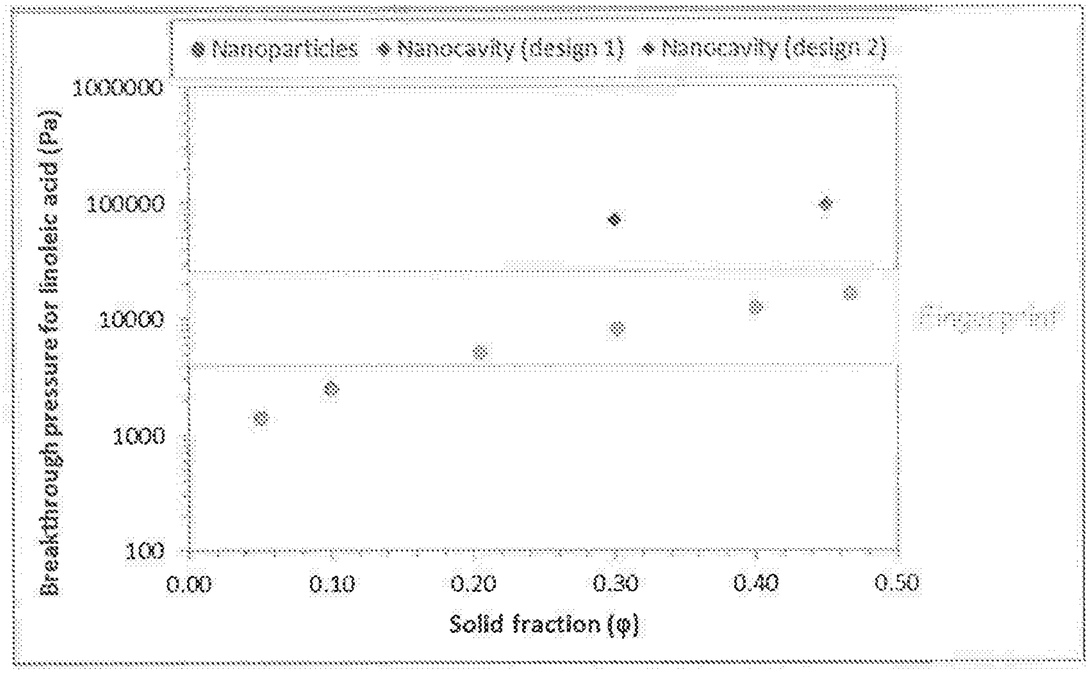
Nanoparticles
Nanocavity (design 1)
Nanocavity (design 2)
Breakthrough pressure for linoleic acid (Pa)
1000000
100000
10000
1000
100
0.00
0.10
0.20
0.30
0.40
0.50
Solid fraction (φ)
fingerprint

Fig. 20

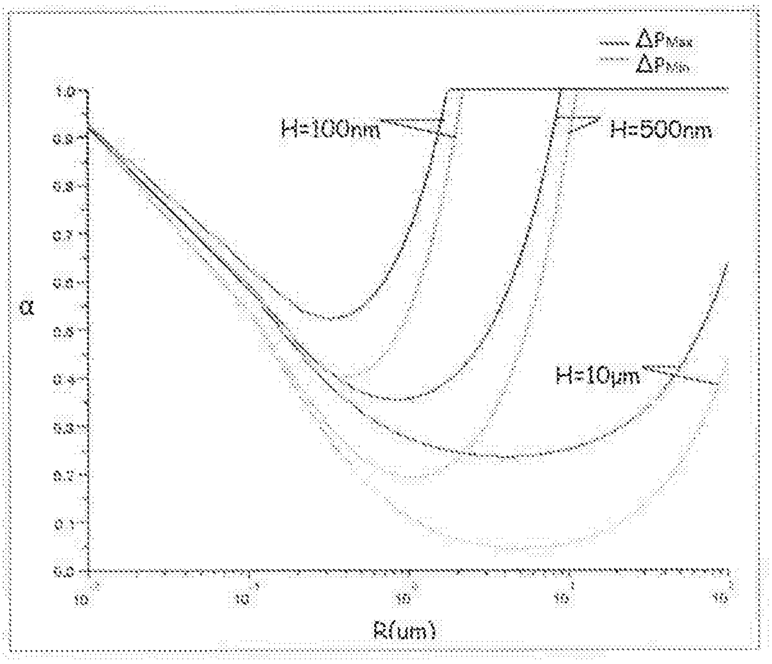
ΔPMax
ΔPMin
H=100nm
H=500nm
H=10μm
α
R(um)

Fig. 21

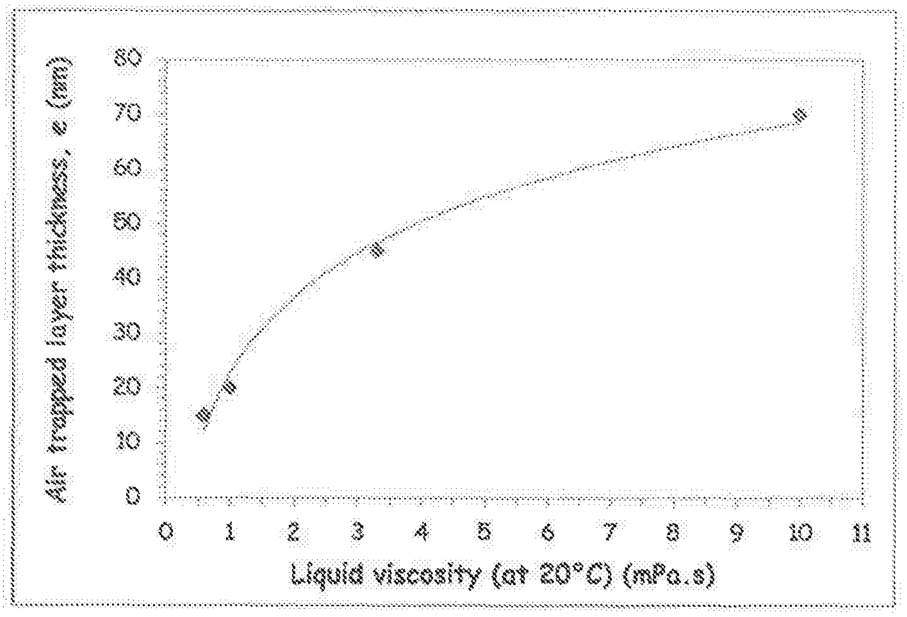
Air trapped layer thickness, e (nm)
80
70
60
50
40
30
20
10
0
0
1
2
3
4
5
6
7
8
9
10
11
Liquid viscosity (at 20°C) (mPa.s)

Fig. 22

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20100112286 A, Bahadur
- WO 2011106196 A, Mazumder
- WO 2011094508 A, Hatton
- WO 2011094344 A, Hatton
- US 6183872 B
- JP 2005187936 A
- EP 1300433 A


### Non-patent literature cited in the description


- Designing Superoleophobic Surfaces. **A. TUTEJA ; W. CHOI ; M.L. MA ; J.M. MABRY ; S.A. MAZZELLA ; G.C. RUTLEDGE ; G.H. MCKINLEY ; R.E. COHEN.** Science. Massachusetts Institute of Technology, 2007, vol. 318, 1618-1622
- A Simple Geometrical Approach to Electrically Tunable Superlyophobic Surfaces. **A. AHUJA ; J.A. TAYLOR ; V. LIFTON ; A.A. SIDORENKO ; T.R. SALAMON ; E.J. LOBATON ; P. KOLODNER ; T.N. KRUPENKIN.** Langmuir. Bell Laboratories, Lucent Technologies, 2008, vol. 24, 9-14
- Design Parameters for Superhydrophobicity and Superoleophobicity. **A. TUTEJA ; W. CHOI ; G.H. MCKINLEY ; R.E. COHEN ; M.F. RUBNER.** MRS Bull. Massachusetts Institute of Technology, 2008, vol. 33, 752-758
- Design and fabrication of microcavity-array superhydrophobic surfaces. **M.C. SALVADORI ; M. CATTANI ; M.R.S. OLIVEIRA ; F.S. TEIXEIRA ; I.G. BROWN.** J. Appl. Phys. University of Sao Paulo, 2010, vol. 108, 024908
- **M. REYSSAT ; A. PEPIN ; F. MARTY ; Y. CHEN ; D. QUERE.** Bouncing transitions on microtextured materials. *Europhys. Lett.,* 2006, vol. 74 (2), 306-312